# EUROPEAN PATENT APPLICATION

(11) **EP 4 509 945 A2**
(43) Date of publication of application: **19.02.2025**
(21) Application number: 24712157.7
(22) Date of filing: 18.03.2024
(51) Int. Cl.: G06F 1/16, H04M 1/02

(54) **ELECTRONIC DEVICE COMPRISING FLEXIBLE DISPLAY SUPPORT STRUCTURE**

(30) Priority: 28.06.2023 KR 20230083418; 19.07.2023 KR 20230094200; 20.07.2023 KR 20230094947; 25.07.2023 KR 20230096839
(71) Applicant: Samsung Electronics Co., Ltd., Suwon-si, Gyeonggi-do 16677 (KR)
(72) Inventor: PARK, Soonik, Suwon-si, Gyeonggi-do 16677 (KR); JEON, Heuisoo, Suwon-si, Gyeonggi-do 16677 (KR); CHOUNG, Taedoo, Suwon-si, Gyeonggi-do 16677 (KR); JUNG, Hunjo, Suwon-si, Gyeonggi-do 16677 (KR); KIM, Suyeon, Suwon-si, Gyeonggi-do 16677 (KR); KIM, Kwangtai, Suwon-si, Gyeonggi-do 16677 (KR); YEOM, Donghyun, Suwon-si, Gyeonggi-do 16677 (KR)
(74) Representative: HGF
(86) International application number: PCT/KR2024/003364
(87) International publication number: WO 2025/005391

(57) **Abstract**

An electronic device includes a display, a hinge structure, a support plate, a first reinforcement plate, and a second reinforcement plate. The display includes a first flat part, a second flat part facing the first flat part in a state in which the electronic device is folded, and a folding part located between the first flat part and the second flat part. The hinge structure below the folding part includes a hinge bracket, a first hinge plate, and a second hinge plate. The first hinge plate and the second hinge plate are configured to fold or unfold the folding part by being rotatably connected to the hinge structure. The support plate includes a plurality of openings located between the hinge structure and the folding part, and extends across the folding part from the first plane part to the second plane part. A front surface of the support plate is attached to a rear surface of the display. The first reinforcement plate is located between the support plate and the hinge structure and is attached to the first hinge plate. The second reinforcement plate is located between the support plate and the hinge structure, and is attached to a rear surface of the support plate. **In** addition, various embodiments are possible.

## Description

### [Technical Field]

The present disclosure relates to an electronic device including a support structure of a flexible display.

### [Background Art]

With development of mobile technology, a foldable smartphone that combines a wide display of a tablet and a compact form factor of a smart phone is being developed. Core technology of such a foldable device is a flexible display technology that may fold or unfold the device without damaging a screen. In particular, since a shape of a folding part of the display, that is, the folding area, changes according to an operation of folding or unfolding the device, it may be difficult to apply a structure that supports it fixedly. Accordingly, it is an important technical task to improve the visual quality (or surface quality) and durability of the folding area where mechanical stress is concentrated while maintaining flexibility.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

According to an embodiment, an electronic device may include a display, a hinge structure, a support plate, a first reinforcement plate, and a second reinforcement plate. The display may include a first flat part, a second flat part facing the first flat part in a state in which the electronic device is folded, and a folding part located between the first flat part and the second flat part. The hinge structure below the folding part, may include a hinge bracket, a first hinge plate, and a second hinge plate. The first hinge plate and the second hinge plate may be configured to fold or unfold the folding part by being rotatably connected to the hinge structure. The support plate may include a plurality of openings located between the hinge structure and the folding part. The support plate may extend across the folding part from the first flat part to the second flat part. A front surface of the support plate may be attached to a rear surface of the display. The first reinforcement plate may be located between the support plate and the hinge structure. The first reinforcement plate may be attached to the first hinge plate. The second reinforcement plate may be located between the support plate and the hinge structure. The second reinforcement plate may be attached to the rear surface of the support plate.

An electronic device according to an embodiment may include a display, a hinge structure, a support plate, a second plate, a first reinforcement plate, and a second reinforcement plate. The display may include a first flat portion, a second flat portion spaced apart from the first flat portion, and a folding portion connecting the first flat portion to the second flat portion. The hinge structure below the folding portion, may include a hinge bracket, a first hinge plate, and a second hinge plate. The first hinge plate and the second hinge plate may be configured to fold or unfold the folding portion by being rotatably coupled to the hinge bracket. The support plate may include a plurality of openings located between the hinge structure and the folding portion, and may extend across the folding portion from the first flat portion to the second flat portion. A front surface of the support plate may be attached to a rear surface of the display. The first plate may include a first portion attached to a rear surface of the support plate to be aligned with the first flat portion and including a second portion attached to the rear surface of the support plate to be aligned with the second flat portion and disconnected from the first portion. The first and second reinforcement plates may be positioned between the first portion and the second portion of the first plate and may be positioned between the support plate and the hinge structure. The hinge structure may be changeable between an unfolded state and a folded state. In the unfolded state, a first direction toward which one surface of the first flat portion faces may be the same as a second direction toward which one surface of the second flat portion faces, and in the folded state, the first direction may be opposite to the second direction. The support plate may include a first section, a second section, and a third section, which are under the folding part. The first section may extend from the second section to the third section. The first section may include a plurality of openings. The second section and the third section may remain flat in the folded state and the unfolded state. In the unfolded state, the first hinge plate may be aligned with the second section, and the second hinge plate may be aligned with the third section. The first reinforcement plate may be attached to the second section of the support plate or the first hinge plate. The second reinforcement plate may be attached to the third section of the support plate or the second hinge plate.

### [Description of the Drawings]

FIG. 1 is a block diagram illustrating an electronic device in a network environment according to various embodiments.
FIG. 2A illustrates an example of an unfolded state of an exemplary electronic device according to an embodiment.
FIG. 2B illustrates an example of a folded state of an exemplary electronic device according to an embodiment.
FIG. 2C is an exploded view of an exemplary electronic device according to an embodiment.
FIG. 2D illustrates an example of an unfolded state of an electronic device according to an embodiment.
FIG. 2E illustrates an example of a folded state of an electronic device according to an embodiment.
FIG. 2F is an exploded view of an electronic device according to an embodiment.
FIG. 3A is a cross-sectional view illustratively indicating an electronic device in an unfolded state according to an embodiment.
FIG. 3B is a cross-sectional view illustratively indicating an electronic device in a folded state according to an embodiment.
FIG. 3C is a cross-sectional view illustratively indicating an electronic device in an unfolded state according to an embodiment.
FIG. 3D is a cross-sectional view illustratively indicating an electronic device in an unfolded state according to an embodiment.
FIG. 3E is a cross-sectional view illustratively indicating an electronic device in an unfolded state according to an embodiment.
FIG. 3F is a cross-sectional view illustratively indicating an electronic device in an unfolded state according to an embodiment.
FIG. 3G is a cross-sectional view illustratively indicating an electronic device in an unfolded state according to an embodiment.
FIG. 3H is a cross-sectional view illustratively indicating an electronic device in an unfolded state according to an embodiment.
FIG. 4A is a cross-sectional view illustratively indicating an electronic device in an unfolded state according to an embodiment.
FIG. 4B is a plan view illustratively indicating an electronic device in an unfolded state according to an embodiment.
FIG. 5A is a cross-sectional view illustratively indicating an electronic device in an unfolded state according to an embodiment.
FIG. 5B is a plan view illustratively indicating an electronic device in an unfolded state according to an embodiment.
FIG. 5C is a plan view illustratively indicating an electronic device in an unfolded state according to an embodiment.
FIG. 6A is a cross-sectional view illustratively indicating an electronic device in an unfolded state according to an embodiment.
FIG. 6B is a cross-sectional view illustratively indicating an electronic device in an unfolded state according to an embodiment.
FIG. 7 is a cross-sectional view illustratively indicating a partial configuration of an electronic device according to an embodiment.

### [Mode for Invention]

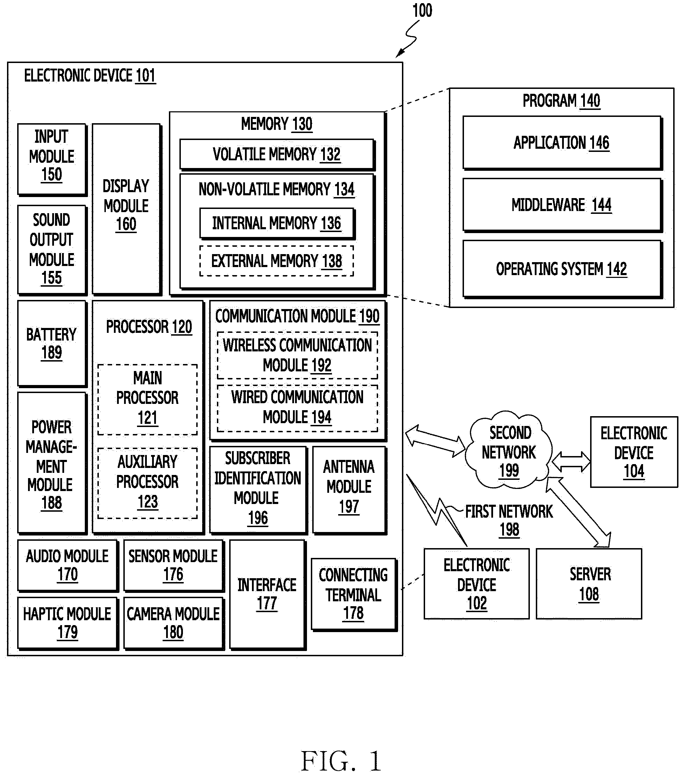

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

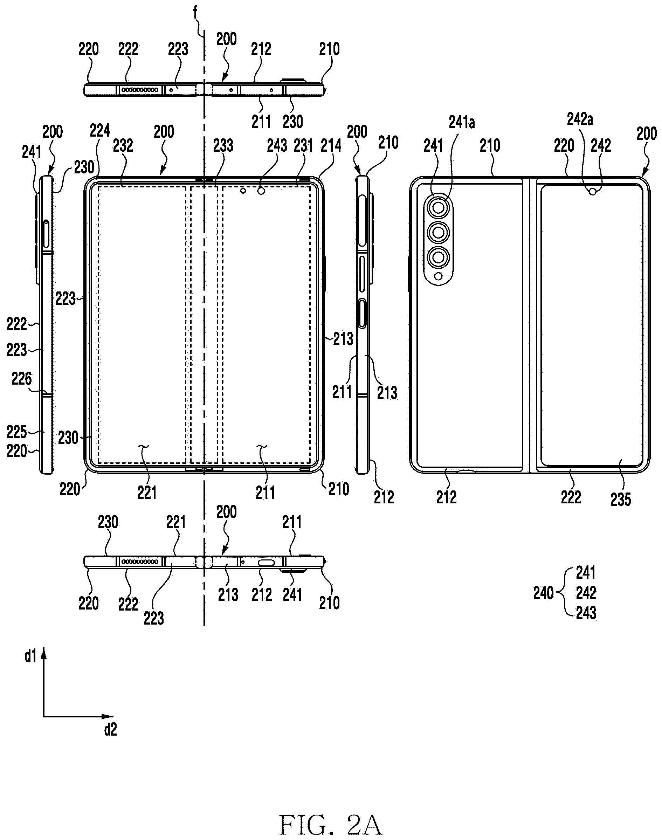

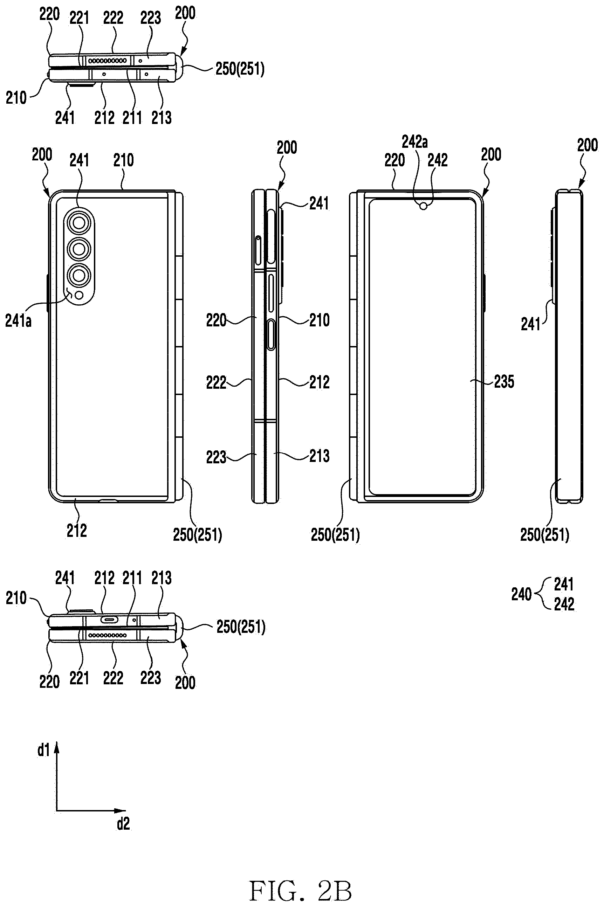

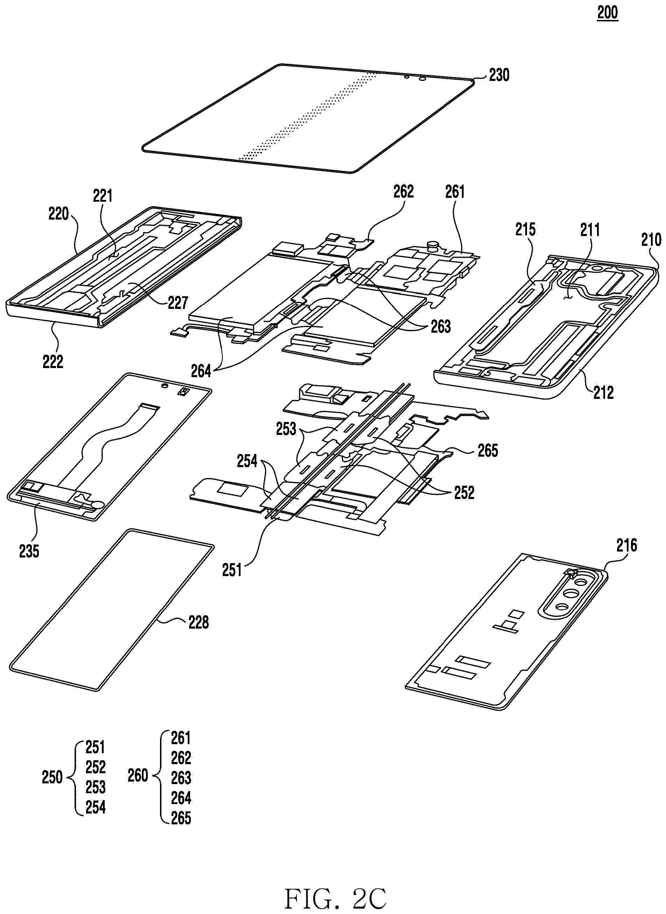

FIG. 2A illustrates an example of an unfolded state of an electronic device according to an embodiment. FIG. 2B illustrates an example of a folded state of an electronic device according to an embodiment. FIG. 2C is an exploded view of an electronic device according to an embodiment.

Referring to FIGS. 2A, 2B, and 2C, an electronic device 200 (e.g., an electronic device 101 of FIG. 1) may include a first housing 210, a second housing 220, and a display 230, at least one camera 240 (e.g., a camera module 180 of FIG. 1), a hinge structure 250, and/or at least one electronic component 260.

The first housing 210 and the second housing 220 may form at least a part of an outer surface of the electronic device 200 that may be gripped by a user. At least a part of the outer surface of the electronic device 200 defined by the first housing 210 and the second housing 220 may contact a part of the user's body when the electronic device 200 is used by the user. According to an embodiment, the first housing 210 may include a first surface 211, a second surface 212 facing the first surface 211 and spaced apart from the first surface 211, and a first side surface 213 surrounding at least a part of the first surface 211 and the second surface 212. The first side surface 213 may connect a periphery of the first surface 211 to a periphery of the second surface 212. The first surface 211, the second surface 212, and the first side surface 213 may define an inner space of the first housing 210. According to an embodiment, the first housing 210 may provide a space formed by the first surface 211, the second surface 212, and the first side surface 213 as a space for disposing components of the electronic device 200.

According to an embodiment, the second housing 220 may include a third surface 221, a fourth surface 222 facing the third surface 221 and spaced apart from the third surface 221, and a second side surface 223 surrounding at least a part of the third surface 221 and the fourth surface 222. The second side surface 223 may connect a periphery of the third surface 221 to a periphery of the fourth surface 222. The third surface 221, the fourth surface 222, and the second side surface 223 may define an inner space of the second housing 220. According to an embodiment, the second housing 220 may provide a space formed by the third surface 221, the fourth surface 222, and the second side surface 223 surrounding at least a part of the third surface 221 and the fourth surface 222 as a space for mounting components of the electronic device 101. According to an embodiment, the second housing 220 may be coupled to the first housing 210 so as to be rotatable with respect to the first housing 210.

According to an embodiment, each of the first housing 210 and the second housing 220 may include a first protection member 214 and a second protection member 224, respectively. The first protection member 214 and the second protection member 224 may be disposed on the first surface 211 and the third surface 221 along a periphery of the display 230. According to an embodiment, the first protection member 214 and the second protection member 224 may prevent inflow of foreign substances (e.g., dust or moisture) through a gap between the display 230, the first housing 210, and the second housing 220. For example, the first protection member 214 may surround a periphery of a first display area 231 of the display 230, and the second protection member 224 may surround a periphery of a second display area 232 of the display 230. The first protection member 214 may be formed by being attached to the first side surface 213 of the first housing 210 or may be integrally formed with the first side surface 213. The second protection member 224 may be formed by being attached to the second side surface 223 of the second housing 220 or may be integrally formed with the second side surface 223.

According to an embodiment, the first side surface 213 and the second side surface 223 may include a conductive material, a non-conductive material, or a combination thereof. For example, the second side surface 223 may include at least one conductive member 225 and at least one non-conductive member 226. The at least one conductive member 225 may include a plurality of conductive members spaced apart from each other, respectively. The at least one non-conductive member 226 may be disposed between the plurality of conductive members. The plurality of conductive members may be disconnected from each other by the at least one non-conductive member 226 disposed between the plurality of conductive members. According to an embodiment, the plurality of conductive members and the plurality of non-conductive members may form an antenna radiator together. The electronic device 200 may be capable of communicating with an external electronic device through the antenna radiator formed by the plurality of conductive members and the plurality of non-conductive members.

The display 230 may be configured to display visual information. According to an embodiment, the display 230 may be disposed on the first surface 211 of the first housing 210 and the third surface 221 of the second housing 220 across the hinge structure 250. For example, the display 230 may include the first display area 231 disposed on the first surface 211 of the first housing, the second display area 232 disposed on the third surface 221 of the second housing, and a third display area 233 disposed between the first display area 231 and the second display area 232. The first display area 231, the second display area 232, and the third display area 233 may form a front surface of the display 230. According to an embodiment, the display 230 may further include a sub-display panel 235 disposed on the fourth surface 222 of the second housing 220. For example, the display 230 may be referred to as a flexible display. According to an embodiment, the display 230 may include a window exposed to the outside of the electronic device 200. The window may protect a surface of the display 230 and transmit visual information provided by the display 230 to the outside of the electronic device 200 by including a substantially transparent material. For example, the window may include, but is not limited to, glass (e.g., UTG, ultra-thin glass) and/or polymer (e.g., PI, polyimide).

The at least one camera 240 may be configured to obtain an image based on receiving light from an external subject of the electronic device 200. According to an embodiment, the at least one camera 240 may include first cameras 241, a second camera 242, and a third camera 243. The first cameras 241 may be disposed in the first housing 210. For example, the first cameras 241 may be disposed inside the first housing 210 and at least a part thereof may be visible through the second surface 212 of the first housing 210. The first cameras 241 may be supported by a bracket (not illustrated) in the first housing 210. The first housing 210 may include at least one opening 241a overlapping the first cameras 241 when the second surface 212 is viewed from above. The first cameras 241 may obtain an image based on receiving light from the outside of the electronic device 200 through the at least one opening 241a.

According to an embodiment, the second camera 242 may be disposed in the second housing 220. For example, the second camera 242 may be disposed inside the second housing 220 and may be visible through the sub-display panel 235. The second housing 220 may include at least one opening 242a overlapping the second camera 242 when the fourth surface 222 is viewed from above. The second camera 242 may obtain the image based on receiving light from the outside of the electronic device 200 through the at least one opening 242a.

According to an embodiment, the third camera 243 may be disposed in the first housing 210. For example, the third camera 243 is disposed inside the first housing 210 and at least a part thereof may be visible through the first surface 211 of the first housing 210. For another example, the third camera 243 may be disposed inside the first housing 210 and at least a part thereof may be visible through the first display area 231 of the display 230. The first display area 231 of the display 230 may include at least one opening (not illustrated) overlapping the third camera 243 when the display 230 is viewed from above. The third camera 243 may obtain the image based on receiving light from the outside of the display 230 through the at least one opening.

According to an embodiment, the second camera 242 and the third camera 243 may be disposed below (e.g., a direction toward the inside of the first housing 210 or the inside of the second housing 220) the display 230. For example, the second camera 242 and the third camera 243 may be an under display camera (UDC). In case that the second camera 242 and the third camera 243 are under-display cameras, one area of the display 230 corresponding to each position of the second camera 242 and the third camera 243 may not be an inactive area. For example, in case that the second camera 242 and the third camera 243 are the under-display cameras, the one area of the display 230 corresponding to each position of the second camera 242 and the third camera 243 may have a pixel density lower than a pixel density of another area of the display 230. The inactive area of the display 230 may mean one area of the display 230 that does not include a pixel or does not emit light to the outside of the electronic device 200. For another example, the second camera 242 and the third camera 243 may be punch hole cameras. In case that the second camera 242 and the third camera 243 are the punch hole cameras, the one area of the display 230 corresponding to each position of the second camera 242 and the third camera 243 may be the inactive area. For example, in case that the second camera 242 and the third camera 243 are the punch hole cameras, the one area of the display 230 corresponding to each position of the second camera 242 and the third camera 243 may include an opening that does not include the pixel.

According to an embodiment, the hinge structure 250 may rotatably connect the first housing 210 and the second housing 220. The hinge structure 250 may be disposed between the first housing 210 and the second housing 220 of the electronic device 101 so that the electronic device 200 may be bent, flexed, or folded. For example, the hinge structure 250 may be disposed between a part of the first side surface 213 and a part of the second side surface 223 facing each other. The hinge structure 250 may be capable of changing the electronic device 200 to an unfolding state in which directions in which the first surface 211 of the first housing 210 and the third surface 221 of the second housing 220 face are substantially the same or a folding state in which the first surface 211 and the third surface 221 face each other. When the electronic device 200 is in the folded state, the first housing 210 and the second housing 220 may be laid over or overlapped by facing each other.

According to an embodiment, when the electronic device 200 is in the folded state, a direction in which the first surface 211 faces and a direction in which the third surface 221 faces may be different from each other. For example, when the electronic device 200 is in the folded state, the direction in which the first surface 211 faces and the direction in which the third surface 221 faces may be opposite to each other. For another example, when the electronic device 200 is in the folded state, the direction in which the first surface 211 faces and the direction in which the third surface 221 faces may be inclined with respect to each other. In case that the direction in which the first surface 211 faces is inclined with respect to the direction in which the third surface 221 faces, the first housing 210 may be inclined with respect to the second housing 220.

According to an embodiment, the electronic device 200 may be foldable based on a folding axis f. The folding axis f may mean a virtual line extending passing a hinge cover 251 in a direction (e.g., d1 of FIGS. 2A and 2B) substantially parallel to a longitudinal direction of the electronic device 200, but is not limited thereto. For example, the folding axis f may be a virtual line extending in a direction (e.g., d2 of FIGS. 2A and 2B) substantially perpendicular to the longitudinal direction of the electronic device 200. In case that the folding axis f extends in the direction substantially perpendicular to the longitudinal direction of the electronic device 200, the hinge structure 250 may connect the first housing 210 and the second housing 220 by extending in a direction parallel to the folding axis f. The first housing 210 and the second housing 220 may be rotatable by the hinge structure 250 extending in the direction substantially perpendicular to the longitudinal direction of the electronic device 200.

According to an embodiment, the hinge structure 250 may include the hinge cover 251, a first hinge plate 252, a second hinge plate 253, and a hinge module 254. The hinge cover 251 may surround internal components of the hinge structure 250 and may form an outer surface of the hinge structure 250. According to an embodiment, at least a part of the hinge cover 251 surrounding the hinge structure 250 may be exposed to the outside of the electronic device 200 through the first housing 210 and the second housing 220 when the electronic device 200 is in the folded state. According to an embodiment, when the electronic device 200 is in the unfolded state, the hinge cover 251 may not be exposed to the outside of the electronic device 200 by being covered by the first housing 210 and the second housing 220. The first hinge plate 252 and the second hinge plate 253 may be referred to as a first wing plate and a second wing plate.

According to an embodiment, the first hinge plate 252 and the second hinge plate 253 may rotatably connect the first housing 210 and the second housing 220 by being coupled to the first housing 210 and the second housing 220, respectively. For example, the first hinge plate 252 may be coupled to a first front surface bracket 215 of the first housing 210, and the second hinge plate 253 may be coupled to a second front surface bracket 227 of the second housing 220. As the first hinge plate 252 and the second hinge plate 253 are coupled to the first front surface bracket 215 and the second front surface bracket 227, respectively, the first housing 210 and the second housing 220 may be rotatable according to rotation of the first hinge plate 252 and the second hinge plate 253.

The hinge module 254 may rotate the first hinge plate 252 and the second hinge plate 253. For example, the hinge module 254 may rotate the first hinge plate 252 and the second hinge plate 253 based on the folding axis f by including gears that engage with each other and are rotatable. According to an embodiment, the hinge module 254 may be plural. For example, a plurality of hinge modules 254 may be disposed by being spaced apart from each other at both ends of the first hinge plate 252 and the second hinge plate 253, respectively.

According to an embodiment, the first housing 210 may include the first front surface bracket 215 and a first rear surface bracket 216, and the second housing 220 may include the second front surface bracket 227 and a second rear surface bracket 228. The first front surface bracket 215 and the first rear surface bracket 216 may support the components of the electronic device 200. The first front surface bracket 215 may define the first housing 210 by being coupled to the first rear surface bracket 216. The first rear surface bracket 216 may define a part of an outer surface of the first housing 210. The second front surface bracket 227 and the second rear surface bracket 228 may support the components of the electronic device 200. The second front surface bracket 227 may define the second housing 220 by being coupled to the second rear surface bracket 228. The second rear surface bracket 228 may define a part of an outer surface of the second housing 220. For example, the display 230 may be disposed on one surface of the first front surface bracket 215 and one surface of the second front surface bracket 227. The first rear surface bracket 216 may be disposed on the other surface of the first front surface bracket 215, which is opposite to the one surface of the first front surface bracket 215. The second rear surface bracket 228 may be disposed on the other surface of the second front surface bracket 227 opposite to the one surface of the second front surface bracket 227. The sub-display panel 235 may be disposed between the second front surface bracket 227 and the second rear surface bracket 228.

According to an embodiment, a part of the first front surface bracket 215 may be surrounded by the first side surface 213, and a part of the second front surface bracket 227 may be surrounded by the second side surface 223. For example, the first front surface bracket 215 may be integrally formed with the first side surface 213, and the second front surface bracket 227 may be integrally formed with the second side surface 223. For another example, the first front surface bracket 215 may be formed separately from the first side surface 213, and the second front surface bracket 227 may be formed separately from the second side surface 223.

The at least one electronic component 260 may implement various functions to be provided to the user. According to an embodiment, the at least one electronic component 260 may include a printed circuit board 261, a printed circuit board 262, a flexible printed circuit board 263, a battery 264 (e.g., a battery 189 of FIG. 1), and/or an antenna 265 (e.g., an antenna module 197 of FIG. 1). The printed circuit board 261 and the printed circuit board 262 may form an electrical connection of components in the electronic device 200, respectively. For example, components (e.g., a processor 120 of FIG. 1) for implementing the overall function of the electronic device 200 may be disposed on the printed circuit board 262, and electronic components for implementing some function of the printed circuit board 261 may be disposed on the printed circuit board 262. For another example, components for an operation of the sub-display panel 235 disposed on the fourth surface 222 may be disposed on the printed circuit board 262.

According to an embodiment, the printed circuit board 261 may be disposed in the first housing 210. The printed circuit board 261 may be disposed on one surface of the first front bracket 215. According to an embodiment, the printed circuit board 262 may be disposed in the second housing 220. For example, the printed circuit board 262 may be spaced apart from the printed circuit board 261 and may be disposed on one surface of the second front bracket 227. The flexible printed circuit board 263 may connect the printed circuit board 261 and the printed circuit board 262. The flexible printed circuit board 263 may extend from the printed circuit board 261 to the printed circuit board 262.

The battery 264 is a device for supplying power to at least one component of the electronic device 200, and may include, for example, a non-rechargeable primary battery, a rechargeable secondary battery, or a fuel cell. At least a part of the battery 264 may be disposed on substantially the same plane as the printed circuit board 261 or the printed circuit board 262.

The antenna 265 may be configured to receive power or a signal from the outside of the electronic device 200. According to an embodiment, the antenna 265 may be disposed between the first rear surface bracket 216 and the battery 264. The antenna 265 may include, for example, a near field communication (NFC) antenna, an antenna module, and/or a magnetic secure transmission (MST) antenna. The antenna 265 may, for example, perform short-distance communication with an external device or wirelessly transmit and receive power required for charging.

Meanwhile, in FIGS. 2A, 2B, and 2C, the electronic device 200 is described as a device operating according to an in-fold method in which the display 230 is not exposed to the outside of the electronic device 200 in a folded state of the electronic device 200, but is not limited thereto. For example, the electronic device 200 may operate according to an out-fold method in which the display 230 is exposed to the outside of the electronic device 200 in the folded state of the electronic device 200. For example, in case that the electronic device 200 is an out-foldable device, the first display area 231, the second display area 232, and the third display area 233 of the display 230 may be exposed to the outside of the electronic device 200 in the folded state of the electronic device 200. For another example, the electronic device 200 may operate in an in-and-out method, in which both the out-fold method and the in-fold method are possible. For another example, the electronic device 200 may further include a third housing rotatably connected to the first housing 210 or the second housing 220. In this case, the electronic device 200 may further include another hinge structure (e.g., the hinge structure 250) that rotatably connects the third housing to the first housing 210 or the second housing 220. The other hinge structure may be configured in the in-fold method, the out-fold method, or the in-and-out method, similar to the one described above.

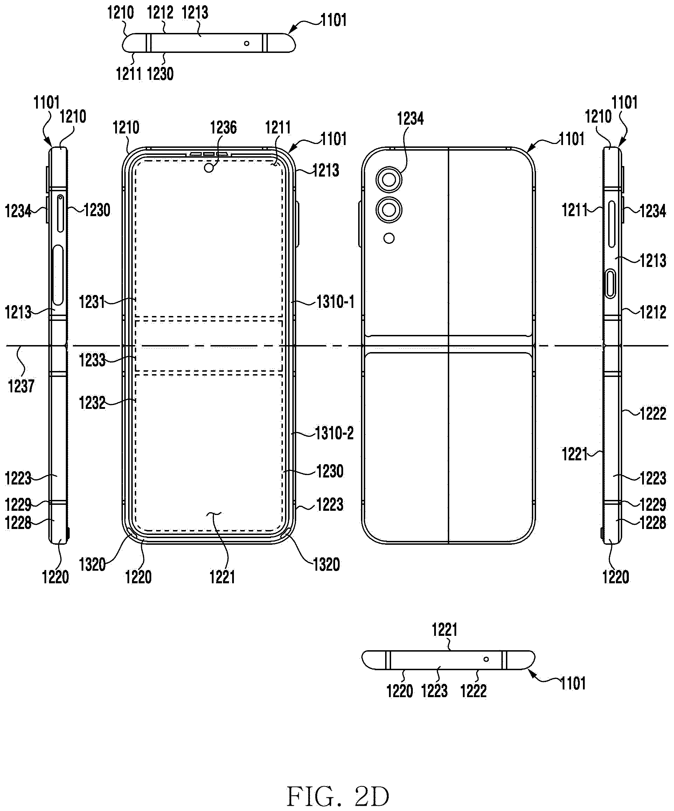

In FIGS. 2A, 2B, and 2C, the electronic device 200 in the unfolded state is illustrated having a long side and a short side and being folded based on the folding axis f parallel to the long side, but it is not limited thereto. For example, unlike the illustration, the electronic device 200 (e.g., an electronic device 1101 of FIG. 2D) may be configured to be folded based on a folding axis (e.g., a folding axis perpendicular to the folding axis f) parallel to the short side.

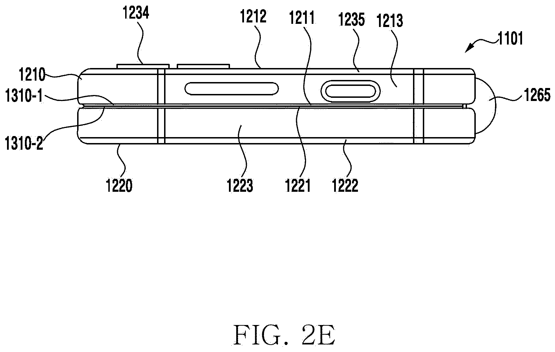

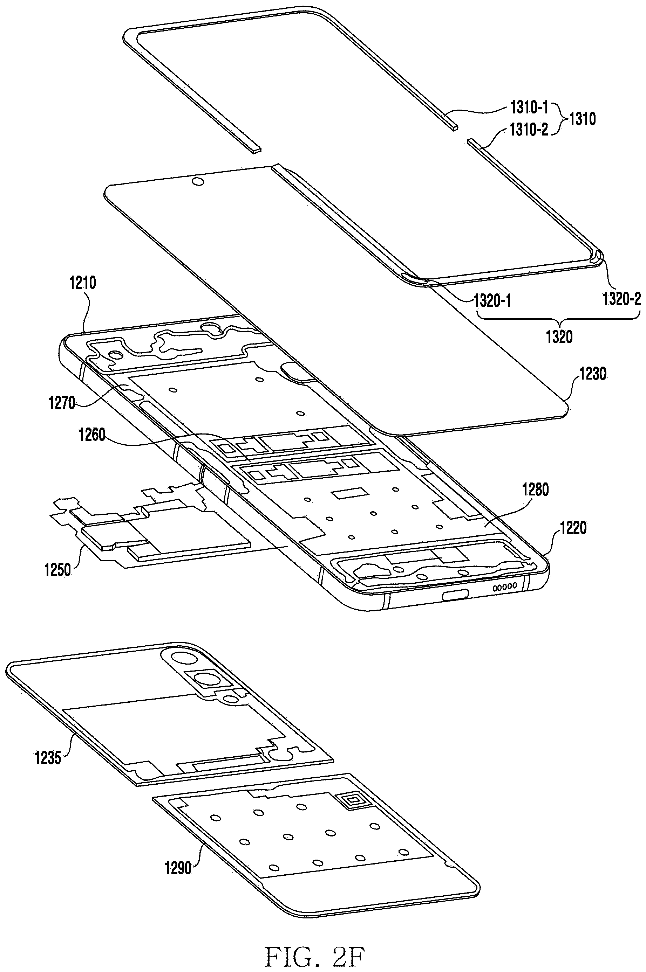

FIG. 2D illustrates an example of an unfolded state of an electronic device according to an embodiment. FIG. 2E illustrates an example of a folded state of an electronic device according to an embodiment. FIG. 2F is an exploded view of an electronic device according to an embodiment.

Referring to FIGS. 2D, 2E, and 2F, an electronic device 1101 (e.g., an electronic device 200 of FIG. 2A) may include a first housing 1210 (e.g., a first housing 210 of FIG. 2A), a second housing 1220 (e.g., a second housing 220 of FIG. 2A), and a flexible display panel 1230 (e.g., a display 230 of FIG. 2A).

In an embodiment, the first housing 1210 may include a first surface 1211, a second surface 1212 faced away the first surface 1211, and a first side surface 1213 surrounding at least a part of the first surface 1211 and the second surface 1212. In an embodiment, the second surface 1212 may further include at least one camera 1234 (e.g., at least one camera 241 of FIG. 2A) and a display panel 1235 (e.g., a sub-display panel 235 of FIG. 2A) exposed through a part of the second surface 1212. In an embodiment, the first housing 1210 may include a first protection member 1310-1 (e.g., a first protection member 214 of FIG. 2A) and a second protection member 1310-2 (e.g., a second protection member 224 of FIG. 2A) disposed along a periphery of the first surface 1211. In an embodiment, the first housing 1210 may provide a space formed by the first surface 1211, the second surface 1212, and the side surface 1213 as a space for disposing components of the electronic device 1101. In an embodiment, the first side surface 1213 and a second side surface 1223 may include a conductive material, a non-conductive material, or a combination thereof. For example, the second side surface 1223 may include a conductive member 1228 and a non-conductive member 1229. The conductive member 1228 may include a plurality of conductive members, and the plurality of conductive members may be spaced apart from each other. The non-conductive member 1229 may be disposed between the plurality of conductive members. An antenna structure may be formed by some or a combination of the plurality of conductive members and the plurality of non-conductive members.

In an embodiment, the second housing 1220 may include a third surface 1221, a fourth surface 1222 faced away the third surface 1221, and a second side surface 1223 surrounding at least a part of the third surface 1221 and the fourth surface 1222. In an embodiment, the fourth surface 1222 may further include a rear surface plate 1290 (e.g., a first rear surface bracket 216 of FIG. 2C) disposed on the fourth surface 1222. According to an embodiment, each of the first housing 1210 and the second housing 1220 may include the first protection member 1310-1 and the second protection member 1310-2, respectively. The first protection member 1310-1 and the second protection member 1310-2 are disposed on the first surface 1211 and the third surface 1221 along a periphery of the flexible display panel 1230. The first protection member 1310-1 and the second protection member 1310-2 may reduce inflow of foreign substances (e.g., dust or moisture) through a gap between the flexible display panel 1230 and the first housing 1210 and the second housing 1220. The first protection member 1310-1 may be disposed along a periphery of a first display area 1231, and the second protection member 1310-2 may be disposed along a periphery of a second display area 1232. The first protection member 1310-1 may be formed by being attached to the first side surface 1213 of the first housing 1210, or may be integrally formed with the first side surface 1213. The second protection member 1310-2 may be formed by being attached to the second side surface 1223 of the second housing 1220, or may be integrally formed with the second side surface 1223.

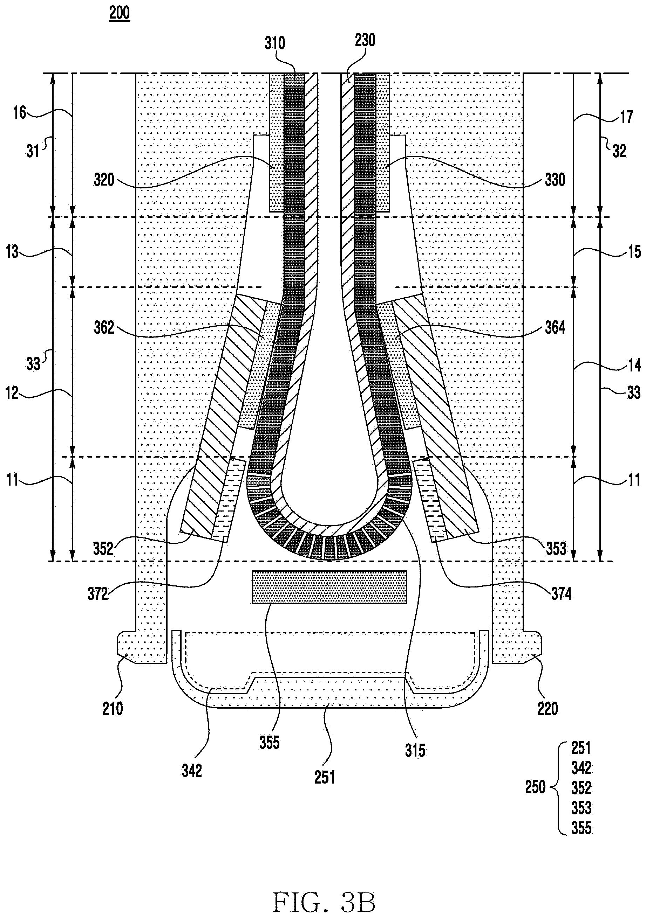

In an embodiment, the second side surface 1223 may be pivotally or rotatably connected to the first side surface 1213 through a hinge structure 1260 (e.g., a hinge structure 250 of FIG. 2C) disposed on a hinge cover 1265 (e.g., a hinge cover 251 of FIG. 2C). The hinge structure 1260 may include a hinge module (e.g., a hinge module 254 of FIG. 2C or a hinge bracket 342 of FIG. 3B) and a hinge plate. The hinge plate may include a first hinge plate (e.g., a first hinge plate 252 of FIG. 2C) and a second hinge plate (e.g., a second hinge plate 253 of FIG. 2C). The first hinge plate may be connected to the first housing 1210, and the second hinge plate may be connected to the second housing 1220. In an example, the second housing 1220 may provide a space formed by the third surface 1221 and the fourth surface 1221 faced away the third surface 1221 and the side surface 1223 surrounding at least a part of the third surface 1221 and the fourth surface 1222 as the space for disposing the components of the electronic device 1101. In an embodiment, the flexible display panel 1230 may include a window exposed to the outside. The window may protect a surface of the flexible display panel 1230, and may transmit visual information provided from the flexible display panel 1230 to the outside by being formed of a transparent member. The window may include a glass material such as ultra-thin glass (UTG) or a polymer material such as polyimide (PI). In an embodiment, the flexible display panel 1230 may be disposed on the first surface 1211 of the first housing 1210 and the third surface 1221 of the second housing 1220 across the hinge cover 1265. The flexible display panel 1230 may include the first display area 1231 disposed on the first surface 1211 of the first housing, the second display area 1232 disposed on the third surface 1221 of the second housing, and a third display area 1233 between the first display area 1231 and the second display area 1232. The first display area 1231, the second display area 1232, and the third display area 1233 may form a front surface of the flexible display panel 1230.

According to an embodiment, an opening may be formed in a part of a screen display area of the flexible display panel 1230, or a recess or the opening may be formed in a support member (e.g., a bracket) supporting the flexible display panel 1230. The electronic device 1101 may include at least one or more camera aligned with the recess or the opening. For example, the first display area 1231 may further include at least one or more camera 1236 capable of obtaining an image from the outside through a part of the first display area 1231. According to an embodiment, the at least one or more camera 1236 may be included on a rear surface of the flexible display panel 1230 corresponding to the first display area 1231 or the second display area 1232 of the flexible display panel 1230. For example, the at least one or more camera 1236 may be disposed below the flexible display panel 1230 and may be surrounded by the flexible display panel 1230. The at least one or more camera 1236 may not be exposed to the outside by being surrounded by the flexible display panel 1230. However, it is not limited thereto, and the flexible display panel 1230 may include an opening exposing the at least one or more camera 1236 to the outside. Although not illustrated in FIGS. 2D and 2E, in an embodiment, the flexible display panel 1230 may further include a rear surface opposite to the front surface. In an embodiment, the flexible display panel 1230 may be supported by a first support member 1270 of the first housing 1210 and a second support member 1280 of the second housing 1220.

In an embodiment, the hinge structure 1260 may be configured to rotatably connect the first support member 1270 that forms the first housing 1210and is fastened to the first hinge plate, and the second support member 1280 that forms the second housing 1220 and is fastened to the second hinge plate.

In an embodiment, the hinge cover 1265 surrounding the hinge structure 1260 may be at least partially exposed through between the first housing 1210 and the second housing 1220 while the electronic device 1101 is in the folded state. In another embodiment, the hinge cover 1265 may be covered by the first housing 1210 and the second housing 1220 while the electronic device 1101 is in the unfolded state.

In an embodiment, the electronic device 1101 may be folded based on a folding axis 1237 passing the hinge cover 1265. For example, the hinge cover 1265 may be disposed between the first housing 1210 and the second housing 1220 of the electronic device 1101 in order to make the electronic device 1101 to be capable of being bent, flexed, or folded. For example, the first housing 1210 may be connected to the second housing 1220 through the hinge structure 1260 disposed on the hinge cover 1265, and may rotate based on the folding axis 1237.

In an embodiment, the electronic device 1101 may be folded so that the first housing 1210 and the second housing 1220 face each other by rotating based on the folding axis 1237. In an embodiment, the electronic device 1101 may be folded so that the first housing 1210 and the second housing 1220 are laid over or overlapped each other.

The electronic device 1101 may include the first housing 1210, the second housing 1220, the hinge structure 1260, the flexible display panel 1230, a printed circuit board 1250, the display panel 1235, the rear surface plate 1290, and the protection member 1310.

The hinge structure 1260 may include the hinge module and the hinge plate. The hinge module may include a hinge gear that makes the first housing 1210 and the second housing 1220 pivotable.

The first housing 1210 may include the first support member 1270 and the second support member 1280. A part of the first support member 1270 may be surrounded by the first side surface 1213, and a part of the second support member 1280 may be surrounded by the second side surface 1223. The first support member 1270 may be integrally formed with the first side surface 1213, and the second support member 1280 may be integrally formed with the second side surface 1223. According to an embodiment, the first support member 1270 may be formed separately from the first side surface 1213, and the second support member 1280 may be formed separately from the second side surface 1223. The first side surface 1213 and the second side surface 1223 may be used as an antenna, by being formed of a metal material, a non-metal material, or a combination thereof.

The first support member 1270 may be coupled to the flexible display panel 1230 on one surface thereof, and may be coupled to the display panel 1235 on the other surface thereof. The second support member 1280 may be coupled to the flexible display panel 1230 on one surface thereof, and may be coupled to the rear surface plate 1290 on the other surface thereof.

The printed circuit board 1250 and a battery may be disposed between a surface formed by the first support member 1270 and the second support member 1280, and a surface formed by the display panel 1235 and the rear surface plate 1290. The printed circuit board 1250 may be separated so as to be disposed on each of the first support member 1270 of the first housing 1210 and the second support member 1280 of the second housing 1220. On the printed circuit board 1250, components for implementing various functions of the electronic device 1101 may be disposed.

The protection member 1310 may be disposed along a periphery of the flexible display panel 1230. The protection member 1310 may reduce damage caused by contact between the first display area 1231 and the second display area 1232 of the flexible display panel 1230 as the electronic device 1101 switches to the folded state. The protection member 1310 may include the first protection member 1310-1 and the second protection member 1310-2. The first protection member 1310-1 may be disposed on the first housing 1210, and the second protection member 1310-2 may be disposed on the second housing 1220. An impact mitigating member 1320 may be disposed on the protection member 1310. The impact mitigating member 1320 may be disposed on any one of the first protection member 1310-1 or the second protection member 1310-2, or may be disposed on the first protection member 1310-1 and the second protection member 1310-2. The impact mitigating member 1320 may be disposed on the second protection member 1310-2. For example, the impact mitigating member 1320 may include a first impact mitigating member 1320-1 and a second impact mitigating member 1320-2. As illustrated in FIG. 2F, the first impact mitigating member 1320-1 and the second impact mitigating member 1320-2 may be disposed on the second protection member 1310-2. Unlike the illustration, the first impact mitigating member 1320-1 or the second impact mitigating member 1320-2 may be disposed on the first protection member 1310-1, or the impact mitigating member 1320 may further include other impact mitigating members disposed on the first protection member 1310-1.

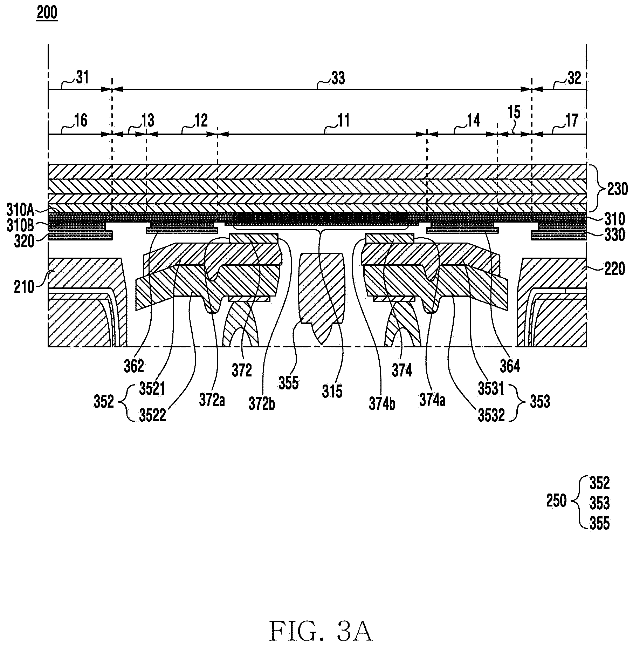

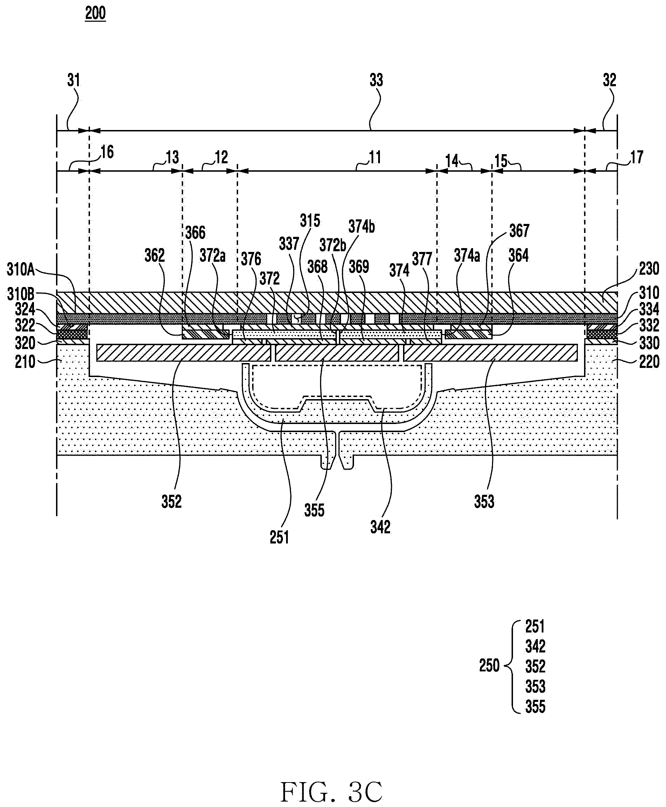

FIG. 3A is a cross-sectional view illustratively indicating an electronic device in an unfolded state according to an embodiment. FIG. 3B is a cross-sectional view illustratively indicating an electronic device in a folded state according to an embodiment. FIG. 3C is a cross-sectional view illustratively indicating an electronic device in an unfolded state according to an embodiment. Hereinafter, a redundant description of a configuration having the same reference numeral as the above-described configuration may be omitted.

Referring to FIGS. 3A, 3B, and 3C, a display 230 (e.g., a display 1230 of FIG. 2D) of an electronic device 200 (e.g., an electronic device 1101 of FIG. 2D) may include a front surface that at least partially forms one surface of the electronic device 200 (e.g., a first surface 211 and a third surface 221 of FIG. 2A or a first surface 1211 and a third surface 1221 of FIG. 2D) and a rear surface opposite to the front surface. In an embodiment, the display 230 may include a first flat part 31 (e.g., a first display area 231 of FIG. 2A or a first display area 1231 of FIG. 2D), a second flat part 32 (e.g., a second display area 232 of FIG. 2A or a second display area 1232 of FIG. 2D) spaced apart from the first flat part 31, and a folding part 33 (e.g., a third display area 233 of FIG. 2A or a third display area 1233 of FIG. 2D) connecting the first flat part 31 to the second flat part 32. The first flat part 31 may be supported by a first housing (or a first bracket) 210 (e.g., a first housing 1210 of FIG. 2D), and the second flat part 32 may be supported by a second housing (or a second bracket) 220 (e.g., a second housing 1220 of FIG. 2D).

The electronic device 200 according to an embodiment may include the unfolded state (e.g., FIG. 3A) and the folded state (e.g., FIG. 3B). The unfolded state may be a state in which a first direction in which one surface (e.g., the front surface) of the first flat part 31 of the display 230 faces and a second direction in which one surface (e.g., the front surface) of the second flat part 32 faces are substantially the same. In the present disclosure, the direction of the first direction and the second direction in the unfolded state may be considered the (positive) vertical direction, and thus any reference to a component being above or below/under another component refers to the relative positions of the components with respect to this direction. The direction perpendicular to the direction of the first direction and the second direction in the unfolded state and perpendicular to the folding axis of the display (e.g., the folding axis f of FIG. 2A) may be considered the horizontal direction. The folded state may be a state in which the first direction and the second direction are opposite to each other. The electronic device 200 may be changed between the unfolded state and the folded state.

In an embodiment, the first flat part 31 and the second flat part 32 may be maintained substantially flat in the folded state or the unfolded state of the electronic device 200. The folding part 33 may be maintained substantially flat in the unfolded state of the electronic device 200, and may be bent as it changes from the unfolded state to the folded state.

The electronic device 200 according to an embodiment may include a first plate 310 extending from the first flat part 31 of the display 230 to the second flat part 32 across the folding part 33. The first plate 310 may be referred to as a support plate. The first plate 310 may include a front surface 310A facing the display 230, a rear surface 310B opposite to the front surface 310A, and a plurality of openings 315 formed between the front surface 310A and the rear surface 310B to penetrate the first plate 310. The plurality of openings 315 may be located between the folding part 33 and a hinge structure (e.g., a hinge structure 250 of FIG. 2C or a hinge structure 1260 of FIG. 2F). For example, the area of the first plate 310 that includes the plurality of openings 315 may at least partially overlap the folding part 33 and the hinge structure 250 based on a direction perpendicular to the first plate 310 in the unfolded state (i.e. based on the vertical direction). The first plate 310 may be formed of a thickness and material capable of supporting the display 230 in the unfolded state while allowing the display 230 to be bent in the folded state. For example, the thickness of the first plate 310 may be approximately 100µm or less, but is not limited thereto. In an embodiment, a width (or a length of a first section 11) of the plurality of openings 315 of the first plate 310 may be approximately 11.15µm, but is not limited thereto. The first plate 310 may be formed of a metal such as stainless steel or a plastic such as carbon fiber reinforced plastic (CFRP), but is not limited thereto.

In an embodiment, the first plate 310 may be disposed on the rear surface of the display 230. For example, the front surface 310A of the first plate 310 may be partially attached to the rear surface of the display 230 through an adhesive member. For example, the first section 11 of the first plate 310 including the plurality of openings 315 may not be attached to the display 230. In this case, the adhesive member may include a first adhesive member that attaches a second section 12, a third section 13, and a sixth section 16 of the first plate 310 to the display 230, and a second adhesive member that is at least partially disconnected from the first adhesive member and attaches a fourth section 14, a fifth section 15, and a seventh section 17 of the first plate 310 to the display 230. The adhesive member may include, for example, a pressure sensitive adhesive (PSA), but is not limited thereto.

In an embodiment, the first plate 310 may include the first section 11, the second section 12, the third section 13, the fourth section 14, the fifth section 15, the sixth section 16, and the seventh section 17.

In an embodiment, the first section 11, the second section 12, the third section 13, the fourth section 14, and the fifth section 15 may be located below the folding part 33 of the display 230. The first section 11 may include the plurality of openings 315. As the plurality of openings 315 are formed in the first section 11, when folding, bending of the folding part 33 may not be hindered, and the folding part 33 may be stably supported in the unfolded state. The first section 11 may be located between the second section 12 and the fourth section 14. For example, the second section 12 may extend from one side of the first section 11, and the fourth section 14 may extend from another side of the first section 11. The second section 12 may extend from the first section 11 to the third section 13. The third section 13 may extend from the second section 12 to the first flat part 31 of the display 230. The fourth section 14 may extend from the first section 11 to the fifth section 15. The fifth section 15 may extend from the fourth section 14 to the second flat part 32 of the display 230.

In an embodiment, the first section 11, the third section 13, and the fifth section 15 may be bent together with the folding part 33 in the folded state. In the folded state, the degree to which the first section 11 is bent may be greater than the degree to which the third section 13 and the fifth section 15 are bent. In the folded state, a curvature sign of the first section 11 may be opposite to a curvature sign of the third section 13 and the fifth section 15. In this regard, the first section 11 and/or a section of the display 230 to which the first section 11 is attached may be referred to as a positive curvature section. In addition, the third section 13 and/or a section of the display 230 to which the third section 13 is attached may be referred to as an inverse (or negative) curvature section. In addition, the fifth section 15 and/or a section of the display 230 to which the fifth section 15 is attached may be referred to as the inverse (or negative) curvature section.

In an embodiment, the first section 11 may be convexly bent toward a hinge cover (e.g., a hinge cover 251 of FIG. 2B or a hinge cover 1265 of FIG. 2E) in the folded state. The first section 11 may be convexly bent toward a first housing 210 in the folded state. The first section 11 may be convexly bent toward a second housing 220 in the folded state. In an embodiment, the third section 13 may be convexly bent toward the second housing 220 in the folded state. In an embodiment, the fifth section 15 may be convexly bent toward the first housing 210 in the folded state. In other words, in the folded state, the first section 11 may be convexly bent towards the rear surface of the electronic device 200, and the third section 13 and fifth section 15 may be convexly bent away from the rear surface of the electronic device 200. That is, in the folded state, the first section 11 is bent one way and the third section 13 and fifth section 15 are bent the other way.

In an embodiment, the second section 12 and the fourth section 14 may be substantially flat in the folded state or the unfolded state. For example, curvature of the second section 12 and curvature of the fourth section 14 may be 0 in the folded state or the unfolded state.

In an embodiment, the sixth section 16 may extend from the third section 13. The sixth section 16 may be disposed on a rear surface of the first flat part 31. The seventh section 17 may extend from the fifth section 15. The seventh section 17 may be disposed on a rear surface of the second flat part 32. The sixth section 16 attached to the first flat part 31 and the seventh section 17 attached to the second flat part 32 may be maintained substantially flat in the folded state or the unfolded state.

In an embodiment, the hinge structure 250 (e.g., the hinge structure 1260 of FIG. 2F) located below the folding part 33 of the display 230 may include a first hinge plate 352 and a second hinge plate 353. Additionally or optionally, the hinge structure 250 may include a center plate (or center bar) 355. In case that the hinge structure 250 does not include the center plate 355, the first hinge plate 352 and the second hinge plate 353 may be further expanded by the section that was occupied by the center plate 355, but are not limited thereto.

In an embodiment, the first hinge plate 352 may include a first member 3521 and a second member 3522 disposed below the first member 3521. The second member 3522 may be coupled to the first member 3521. Alternatively, unlike the illustration of FIG. 3A, the first hinge plate 352 may be formed as one member in which the first member 3521 and the second member 3522 are integrated. In an embodiment, the second hinge plate 353 may include a first member 3531 and a second member 3532 disposed below the first member 3531. The second member 3532 may be coupled to the first member 3531. Alternatively, unlike the illustration of FIG. 3A, the second hinge plate 353 may be formed as one member in which the first member 3531 and the second member 3532 are integrated.

In an embodiment, the first hinge plate 352 and the second hinge plate 353 may be rotatably coupled to a hinge bracket 342 (e.g., a hinge module 254 of FIG. 2C). The first hinge plate 352 and the second hinge plate 353 may be configured to fold or unfold the folding part 33 of the display 230 as they rotate with respect to the hinge bracket 342. In the unfolded state, based on a direction perpendicular to the first plate 310 in the unfolded state (i.e. based on the vertical direction), a first portion of the first hinge plate 352 may overlap the first section 11, the second portion may overlap the third section 13, and the remaining portion between the first portion and the second portion may overlap the second section 12. In the unfolded state, based on a direction perpendicular to the first plate 310 in the unfolded state (i.e. based on the vertical direction), the first portion of the second hinge plate 353 may overlap the first section 11, the second portion may overlap the fifth section 15, and the remaining portion between the first portion and the second portion of the second hinge plate 353 may overlap the fourth section 14. In an embodiment, a thickness of the first hinge plate 352 and/or the second hinge plate 353 may be approximately 50µm, but is not limited thereto.

In an embodiment, the center plate 355 may be located between the first hinge plate 352 and the second hinge plate 353 based on the unfolded state. The center plate 355 may be located between the folding part 33 of the display 230 and the hinge cover 251 (e.g., the hinge cover 1265 of FIG. 2E). The center plate 355 may be formed in a plate shape extending in a longitudinal direction along a folding axis (e.g., a folding axis f of FIG. 2A) of the display 230. The center plate 355 may support the folding part 33 of the display 230 in the unfolded state. The center plate 355 and the hinge cover 251 may be aligned in the first section 11 of the first plate 310. For example, the center plate 355 and the hinge cover 251 may be aligned in a center of the first section 11 based on a direction perpendicular to the first plate 310 in the unfolded state (i.e. based on the vertical direction). For example, a center of the center plate 355, a center of the hinge cover 251, and the center of the first section 11 may coincide with each other, but are not limited thereto.

In an embodiment, the first housing 210 and the second housing 220 may be rotatably connected to the hinge bracket 342. For example, although not illustrated, the hinge structure 250 may include a first rotating plate (e.g., a first hinge plate 252 of FIG. 2C) and a second rotating plate (e.g., a second hinge plate 253 of FIG. 2C) rotatably coupled to the hinge bracket 342. The first housing 210 and the second housing 220 may be connected to a first rotating plate 252 and a second rotating plate 253 respectively, and may rotate according to rotation of the first rotating plate 252 and the second rotating plate 253. In an embodiment, the first hinge plate 352 may rotate at an angle and/or path different from that of the first rotating plate 252, and the second hinge plate 353 may rotate at an angle and/or path different from that of the second rotating plate 253.

The electronic device 200 according to an embodiment may include a second plate 320 and a third plate 330. In an embodiment, the second plate 320 may be disposed on the rear surface 310B of the first plate 310 to be aligned with the first flat part 31 of the display 230 based on a direction perpendicular to the first plate 310 in the unfolded state (i.e. based on the vertical direction). For example, the second plate 320 may be disposed on the rear surface 310B of the sixth section 16 of the first plate 310 attached to the first flat part 31. For example, the second plate 320 may be attached on the rear surface 310B of the sixth section 16. In an embodiment, the third plate 330 may be disposed on the rear surface 310B of the first plate 310 to be aligned with the second flat part 32 of the display 230 based on a direction perpendicular to the first plate 310 in the unfolded state (i.e. based on the vertical direction). For example, the third plate 330 may be disposed on the rear surface 310B of the seventh section 17 of the first plate 310 attached to the second flat part 32. For example, the third plate 330 may be attached on the rear surface 310B of the seventh section 17.

In an embodiment, the second plate 320 may be disposed only on the sixth section 16 of the sections of the first plate 310 and may not be disposed on other sections. In an embodiment, the third plate 330 may be disposed only on the seventh section 17 of the sections of the first plate 310 and may not be disposed on other sections. In order to form the positive curvature section and the inverse curvature section on the display 230, the second plate 320 and the third plate 330 may not be formed on the rear surface 310B of the first section 11, the second section 12, the third section 13, the fourth section 14, and the fifth section 15 below the folding part 33. For example, in case that the second plate 320 and the third plate 330 are disposed on the entire section (e.g., the first section 11 to the seventh section 17) of the first plate 310, due to rigidity of the second plate 320 and the third plate 330, the positive curvature section and the inverse curvature section of the display 230 may not be formed and interference with the hinge structure 250 may occur. In case that a thicknesses of the second plate 320 and the third plate 330 are reduced in order to reduce the rigidity of the second plate 320 and the third plate 330, surface quality of the first flat part 31 and the second flat part 32 may be deteriorated by not sufficiently supporting the first flat part 31 and the second flat part 32.

In an embodiment, the second plate 320 and/or the third plate 330 may be formed of a metal alloy such as stainless steel and a copper alloy, but is not limited thereto. In an embodiment, in case that the second plate 320 and/or the third plate 330 are formed of a material with excellent thermal conductivity, such as the copper alloy, heat dissipation performance of the electronic device 200 may be improved. For example, the second plate 320 and/or the third plate 330 may be formed of a material with a thermal conductivity of at least 300 W/m K at 20°C, but are not limited thereto. In an embodiment, a thickness of the second plate 320 and/or the third plate 330 may be 50µm to 100µm, but is not limited thereto.

The electronic device 200 according to an embodiment may include a first reinforcement plate 372, a second reinforcement plate 362, a third reinforcement plate 374, and a fourth reinforcement plate 364. The first reinforcement plate 372, the second reinforcement plate 362, the third reinforcement plate 374, and the fourth reinforcement plate 364 may be formed of, for example, a material having rigidity for supporting the display 230. For example, the first reinforcement plate 372, the second reinforcement plate 362, the third reinforcement plate 374, and the fourth reinforcement plate 364 may be formed of an alloy such as metal or stainless steel, but are not limited thereto. For example, at least one of the first reinforcement plate 372, the second reinforcement plate 362, the third reinforcement plate 374, and the fourth reinforcement plate 364 may be formed of the material with excellent thermal conductivity, such as the copper alloy, in order to improve the heat dissipation performance. For example, at least one of the first reinforcement plate 372, the second reinforcement plate 362, the third reinforcement plate 374, and the fourth reinforcement plate 364 may be formed of a material with a thermal conductivity of at least 300 W/m K at 20°C, but are not limited thereto. The thicknesses of the first reinforcement plate 372, the second reinforcement plate 362, the third reinforcement plate 374, and the fourth reinforcement plate 364 may be, for example, approximately 50µm or more, but are not limited thereto. The thicknesses of the first reinforcement plate 372, the second reinforcement plate 362, the third reinforcement plate 374, and the fourth reinforcement plate 364 may be the same each other, but are not limited thereto. For example, the first reinforcement plate 372, the second reinforcement plate 362, the third reinforcement plate 374, and the fourth reinforcement plate 364 may have at least one thickness different from each other. In an embodiment, the thickness of each of the first reinforcement plate 372, the second reinforcement plate 362, the third reinforcement plate 374, and the fourth reinforcement plate 364 may be formed to a maximum thickness in a range that does not interfere with another component, but is not limited thereto.

In an embodiment, the first reinforcement plate 372 may be located between the first plate 310 and the hinge structure 250 based on a direction perpendicular to the first plate 310 in the unfolded state (i.e. based on the vertical direction). That is, an upper surface of the first reinforcement plate 372 may face the first plate 310 and a rear surface of the first reinforcement plate 372 may face the hinge structure 250. The first reinforcement plate 372 may be disposed on the first hinge plate 352. For example, the first reinforcement plate 372 may be attached to the first hinge plate 352. For example, the first reinforcement plate 372 may be attached at least partially on the first hinge plate 352 through an adhesive member 376.

In an embodiment, the first reinforcement plate 372 may at least partially overlap the first section 11 based on the direction perpendicular to the first plate 310 in the unfolded state (i.e. based on the vertical direction). For example, as illustrated in FIG. 3A, the entire first reinforcement plate 372 may overlap the first section 11. For another example, as illustrated in FIG. 3C, a part of the first reinforcement plate 372 may overlap the first section 11, and the remaining part may overlap the second section 12.

In an embodiment, the second reinforcement plate 362 may be disposed on the rear surface 310B of the first plate 310. For example, the second reinforcement plate 362 may be disposed on the rear surface 310B of the first plate 310 and may be disposed between the second plate 320 and the first reinforcement plate 372 in the direction parallel to the first plate 310 in the unfolded state and perpendicular to the folding axis (i.e. in the horizontal direction). For example, the second reinforcement plate 362 may be disposed on the rear surface 310B of the second section 12 of the first plate 310. The second reinforcement plate 362 may be attached at least partially on the rear surface 310B of the second section 12. For example, the second reinforcement plate 362 may be attached through an adhesive member 366. The adhesive member 366 may include the pressure sensitive adhesive (PSA), but is not limited thereto.

The second reinforcement plate 362 may be spaced apart from the second plate 320. For example, the second reinforcement plate 362 may be spaced apart from the second plate 320 by a length of the third section 13 of the first plate 310, but is not limited thereto.

Since the third section 13 is bent according to the folded state or the unfolded state, even if the second reinforcement plate 362 is attached to the third section 13, it may be easily separated. Thus, the second reinforcement plate 362 may not be attached to the third section 13 of the first plate 310, but is not limited thereto.

In addition, since the third section 13 is bent according to the folded state or the unfolded state, in case that the second reinforcement plate 362 extends to the third section 13, interference with the display 230 may occur. Thus, the second reinforcement plate 362 may not overlap the third section 13 based on the direction perpendicular to the first plate 310 in the unfolded state (i.e. the vertical direction), but is not limited thereto.

In an embodiment, the third reinforcement plate 374 may be located between the first plate 310 and the hinge structure 250 based on a direction perpendicular to the first plate 310 in the unfolded state (i.e. based on the vertical direction). That is, an upper surface of the third reinforcement plate 374 may face the first plate 310 and a rear surface of the third reinforcement plate 374 may face the hinge structure 250. The third reinforcement plate 374 may be disposed on the second hinge plate 353. For example, the third reinforcement plate 374 may be attached to the first hinge plate 352. For example, the third reinforcement plate 374 may be attached at least partially on the second hinge plate 353 through an adhesive member 377.

In an embodiment, the third reinforcement plate 374 may at least partially overlap the first section 11 based on the direction perpendicular to the first plate 310 in the unfolded state (i.e. based on the vertical direction). For example, as illustrated in FIG. 3A, the entire third reinforcement plate 374 may overlap the first section 11. For another example, as illustrated in FIG. 3C, a part of the third reinforcement plate 374 may overlap the first section 11, and the remaining part may overlap the fourth section 14.

In an embodiment, the fourth reinforcement plate 364 may be disposed on the rear surface 310B of the first plate 310. For example, the fourth reinforcement plate 364 may be disposed on the rear surface 310B of the first plate 310 and may be disposed between the third plate 330 and the third reinforcement plate 374 in the direction parallel to the first plate 310 in the unfolded state and perpendicular to the folding axis (i.e. in the horizontal direction). For example, the fourth reinforcement plate 364 may be disposed on the rear surface 310B of the fourth section 14 of the first plate 310. The fourth reinforcement plate 364 may be attached at least partially on the rear surface 310B of the fourth section 14. For example, the fourth reinforcement plate 364 may be attached through an adhesive member 367. The adhesive member 367 may include the pressure sensitive adhesive (PSA), but is not limited thereto.

The fourth reinforcement plate 364 may be spaced apart from the third plate 330. For example, the fourth reinforcement plate 364 may be spaced apart from the third plate 330 by a length of the fifth section 15 of the first plate 310, but is not limited thereto.

Since the fifth section 15 is bent according to the folded state or the unfolded state, even if the fourth reinforcement plate 364 is attached to the fifth section 15, it may be easily separated. Thus, the fourth reinforcement plate 364 may not be attached to the fifth section 15 of the first plate 310, but is not limited thereto.

In addition, since the fifth section 15 is bent according to the folded state or the unfolded state, in case that the fourth reinforcement plate 364 extends to the fifth section 15, interference with the display 230 may occur. Thus, the fourth reinforcement plate 364 may not overlap the fifth section 15 based on the direction perpendicular to the first plate 310 in the unfolded state, but is not limited thereto.

In an embodiment, the first reinforcement plate 372 may include a first side 372a and a second side 372b opposite to the first side 372a. In the unfolded state, the first side 372a of the first reinforcement plate 372 may face the second plate 320 (and/or the second reinforcement plate 362). In the unfolded state, the second side 372b of the first reinforcement plate 372 may face the third reinforcement plate 374. In the unfolded state, the second side 372b of the first reinforcement plate 372 may be located below the first section 11. For example, the second side 372b of the first reinforcement plate 372 may be located between the first section 11 of the first plate 310 and the hinge cover 251 based on a direction perpendicular to the first plate 310 in the unfolded state (i.e. based on the vertical direction).

In an embodiment, the third reinforcement plate 374 may include a first side 374a and a second side 374b opposite to the first side 374a. In the unfolded state, the first side 374a of the third reinforcement plate 374 may face the third plate 330 (and/or the fourth reinforcement plate 364). In the unfolded state, the second side 374b of the third reinforcement plate 374 may face the first reinforcement plate 372 (or the second side 372b of the second reinforcement plate 362). In the unfolded state, the second side 374b of the third reinforcement plate 374 may be located below the first section 11. For example, the second side 374b of the third reinforcement plate 374 may be located between the first section 11 of the first plate 310 and the hinge cover 251 based on a direction perpendicular to the first plate 310 in the unfolded state (i.e. based on the vertical direction).

As illustrated in FIG. 3A, the second side 372b of the first reinforcement plate 372 and the second side 374b of the third reinforcement plate 374 may be spaced apart from each other. The second side 372b of the first reinforcement plate 372 may overlap the first hinge plate 352, and the second side 374b of the third reinforcement plate 374 may overlap the second hinge plate 353, but is not limited thereto. For example, the first reinforcement plate 372 and the third reinforcement plate 374 supporting the folding part 33 of the display 230 in the unfolded state may be configured to expand its area. In other words, in order to improve a supporting effect of the folding part 33, the first reinforcement plate 372 and the third reinforcement plate 374 may be formed so that a distance between the second side 372b and the second side 374b is reduced in the unfolded state. For example, as illustrated in FIG. 3C, the first reinforcement plate 372 may extend beyond the first hinge plate 352 to the center plate 355 (or the center of the first section 11), and the third reinforcement plate 374 may extend beyond the second hinge plate 353 to the center plate 355 (or the center of the first section 11). In this case, in the unfolded state, the first reinforcement plate 372 may partially overlap the center plate 355. In addition, in the unfolded state, the third reinforcement plate 374 may partially overlap the center plate 355.

In an embodiment, the first reinforcement plate 372, the second reinforcement plate 362, the third reinforcement plate 374, and the fourth reinforcement plate 364 may support a rear surface of the first plate 310 in the unfolded state. For example, the first reinforcement plate 372, the second reinforcement plate 362, the third reinforcement plate 374, and the fourth reinforcement plate 364 may support the first section 11, the second section 12, and the fourth section 14 of the first plate 310 in the unfolded state. Additionally, in case that the second reinforcement plate 362 extends further toward the second plate 320 than the illustrated example, the second reinforcement plate 362 may support the third section 13 of the first plate 310. Additionally, in case that the fourth reinforcement plate 364 extends further toward the third plate 330 than the illustrated example, the fourth reinforcement plate 364 may support the fifth section 15 of the first plate 310. Through this, the folding part 33 of the display 230 may be supported in the unfolded state, and the visual quality (or surface quality) of the folding part 33 may be improved. For example, a problem in which a wrinkle is formed on the folding part 33 of the display 230 or components inside the folding part 33 are visible in the unfolded state may be prevented. In addition, the first reinforcement plate 372 and the third reinforcement plate 374 may not interfere with shape deformation of the folding part 33 according to the folded state or the unfolded state, by being attached to the first hinge plate 352 and the second hinge plate 353. In addition, the second reinforcement plate 362 and the fourth reinforcement plate 364 may not interfere with the shape deformation of the folding part 33 according to the folded state or the unfolded state, by being attached to the second section 12 and the fourth section 14 without curvature. In other words, the first reinforcement plate 372, the second reinforcement plate 362, the third reinforcement plate 374, and the fourth reinforcement plate 364 may improve the surface quality of the folding part 33 while allowing the folding part 33 to be bent according to a folding operation of the electronic device 200.

Referring to FIG. 3C, the electronic device 200 according to an embodiment may further include a first step compensation member 368 and a second step compensation member 369. The first step compensation member 368 and the second step compensation member 369 may include, for example, a metal, a plastic, or an elastic body, but are not limited thereto.

In an embodiment, the first step compensation member 368 may be attached onto the first reinforcement plate 372. For example, the first step compensation member 368 may be attached to a rear surface of the first reinforcement plate 372 facing the first hinge plate 352 in the unfolded state. The first step compensation member 368 may be attached avoiding an area where the first reinforcement plate 372 is attached to the first hinge plate 352. In other words, the adhesive member 376 attaching the first reinforcement plate 372 to the first hinge plate 352 may be disposed on a part of the rear surface of the first reinforcement plate 372, and the first step compensation member 368 may be disposed on another part of the rear surface. The first step compensation member 368 attached to the first reinforcement plate 372 may be supported by the first hinge plate 352 and/or the center plate 355 in the unfolded state. For example, the first step compensation member 368 may contact the first hinge plate 352 and/or the center plate 355 in the unfolded state, and may be spaced apart from the first hinge plate 352 and/or the center plate 355 in the folded state. Through this, inclination of the first reinforcement plate 372 and the display 230 may be made parallel in the unfolded state, and the surface quality of the folding part 33 supported by the first reinforcement plate 372 may be improved.

In an embodiment, the second step compensation member 369 may be attached onto the third reinforcement plate 374. For example, the second step compensation member 369 may be attached to a rear surface of the third reinforcement plate 374 facing the second hinge plate 353 in the unfolded state. The second step compensation member 369 may be attached avoiding an area where the third reinforcement plate 374 is attached to the second hinge plate 353. In other words, the adhesive member 377 attaching the third reinforcement plate 374 to the second hinge plate 353 may be disposed on a part of the rear surface of the third reinforcement plate 374, and the second step compensation member 369 may be disposed on another part of the rear surface. The second step compensation member 369 attached to the third reinforcement plate 374 may be supported by the second hinge plate 353 and/or the center plate 355 in the unfolded state. For example, the second step compensation member 369 may contact the second hinge plate 353 and/or the center plate 355 in the unfolded state, and may be spaced apart from the second hinge plate 353 and/or the center plate 355 in the folded state. Through this, the inclination of the third reinforcement plate 374 and the display 230 may be made parallel in the unfolded state, and the surface quality of the folding part 33 supported by the third reinforcement plate 374 may be improved.

The electronic device 200 according to an embodiment may include a first adhesive layer 322, a first elastic layer 324, a second adhesive layer 332, and a second elastic layer 334. The first adhesive layer 322 may be interposed between the first plate 310 and the second plate 320 based on a direction perpendicular to the first plate 310 in the unfolded state (i.e. based on the vertical direction). The first adhesive layer 322 may attach the second plate 320 to the first plate 310. The first elastic layer 324 may be interposed between the first plate 310 and the second plate 320 based on a direction perpendicular to the first plate 310 in the unfolded state (i.e. based on the vertical direction). For example, the first elastic layer 324 may be interposed between the first plate 310 and the first adhesive layer 322 based on a direction perpendicular to the first plate 310 in the unfolded state (i.e. based on the vertical direction). The second adhesive layer 332 may be interposed between the first plate 310 and the third plate 330 based on a direction perpendicular to the first plate 310 in the unfolded state (i.e. based on the vertical direction). The second adhesive layer 332 may attach the third plate 330 to the first plate 310. The second elastic layer 334 may be interposed between the first plate 310 and the third plate 330 based on a direction perpendicular to the first plate 310 in the unfolded state (i.e. based on the vertical direction). For example, the second elastic layer 334 may be interposed between the first plate 310 and the second adhesive layer 332 based on a direction perpendicular to the first plate 310 in the unfolded state (i.e. based on the vertical direction). In an embodiment, the first adhesive layer 322 and the second adhesive layer 332 may include the pressure sensitive adhesive (PSA), but are not limited thereto. In an embodiment, the first adhesive layer 322 and/or the second adhesive layer 332 may be formed of a plurality of layers. For example, the plurality of layers may include a first layer, a second layer, and a third layer interposed between the first layer and the second layer. The third layer may include, for example, a film formed of polyimide, but is not limited thereto. The first layer may include an adhesive layer attached to the first plate 310. The second layer may include an adhesive layer attached to the second plate 320 or the third plate 330. The first layer and the second layer may be formed to have different adhesive forces, but are not limited thereto. The first layer may include the pressure sensitive adhesive (PSA), and the second layer may include an adhesive other than the pressure sensitive adhesive (PSA), but is not limited thereto. As the first adhesive layer 322 and/or the second adhesive layer 332 are formed of the plurality of layers, a damping effect provided by the first adhesive layer 322 and/or the second adhesive layer 332 may be improved.

In an embodiment, the first elastic layer 324 and the second elastic layer 334 may include a material capable of absorbing impact. For example, the first elastic layer 324 and the second elastic layer 334 may be formed of thermoplastic Polyurethane (TPU), but are not limited thereto.

The electronic device 200 according to an embodiment may include a protective layer 337 disposed on the rear surface 310B of the first plate 310 to cover the plurality of openings 315. For example, the protective layer 337 may be disposed on the rear surface 310B of the first section 11 of the first plate 310. The protective layer 337 may be attached onto the rear surface 310B of the first plate 310 through, for example, the adhesive member. The protective layer 337 may be formed to have a larger width than the plurality of openings 315 to cover the plurality of openings 315. For example, a width of the protective layer 337 may be approximately 12.15µm, but is not limited thereto. The width of the protective layer 337 may be a length based on a direction parallel to the first plate 310 in the unfolded state and perpendicular to a folding axis (e.g., a folding axis 1237 of FIG. 2D). In an embodiment, a thickness (i.e. a thickness in the vertical direction) of the protective layer 337 may be approximately 8µm, but is not limited thereto. The protective layer 337 may be formed of a flexible material. For example, the protective layer 337 may be formed of thermoplastic Polyurethane (TPU), but is not limited thereto. The protective layer 337 may alleviate an impact that may be applied to the folding part 33 of the display 230, and may prevent foreign substances from flowing into the plurality of openings 315.

Although not illustrated, the electronic device 200 according to an embodiment may include a printed circuit board (e.g., a printed circuit board 261 or a printed circuit board 262 of FIG. 2C) supported by the first housing 210 or the second housing 220 and a heat source disposed on the printed circuit board. The heat source may include, for example, an application processor (e.g., a processor 120 of FIG. 1) or a power management integrated circuit (PMIC) (e.g., a power management module 188 of FIG. 1) but is not limited thereto.

The first housing 210 and/or the second housing 220 may be rotatably connected to the hinge structure 250. In other words, since the first housing 210 or the second housing 220 in which the heat source is located is not integrally formed with the hinge structure 250 and is a member independent of the hinge structure 250, it may be disadvantageous in spreading heat by the heat source or dissipating it to the outside. Due to interference with the hinge structure 250, it may also be difficult to dispose a separate heat dissipation member adjacent to the hinge structure 250. This may be because a distance between the first hinge plate 352 and the second hinge plate 353 changes according to the folded state and the unfolded state in order for the display 230 to form the positive curvature section and the inverse curvature section.

In order to improve the heat dissipation performance, a material with high thermal conductivity may be applied. However, since a material with good thermal conductivity generally has a low Young's modulus, in case that a configuration supporting the display 230 is made of such a material, it may be disadvantageous to surface quality of the display 230.

In order to improve the heat dissipation performance, the second plate 320 and the third plate 330 may be expanded. However, in case that the second plate 320 and the third plate 330 extend to the folding part 33, the positive curvature section and/or the inverse curvature section of the folding part 33 may not be formed, and the display 230 may be damaged by interfering with the hinge structure 250.

In an embodiment, in case that the heat source is located in the first housing 210, at least one of the first housing 210, the first plate 310, the second plate 320, the first reinforcement plate 372, and the second reinforcement plate 362 may be formed of a material with higher thermal conductivity than the second housing 220. In an embodiment, in case that the heat source is located in the second housing 220, at least one of the second housing 220, the first plate 310, the third plate 330, the third reinforcement plate 374, and the fourth reinforcement plate 364 may be formed of a material with higher thermal conductivity than the first housing 210. In an embodiment, at least one of the first housing 210, the second housing 220, the first plate 310, the second plate 320, the third plate 330, the first reinforcement plate 372, the second reinforcement plate 362, the third reinforcement plate 374, and the fourth reinforcement plate 364 may be formed of a material with high thermal conductivity. The material with high thermal conductivity may include, for example, the copper alloy or the copper alloy plated with nickel, but is not limited thereto. Through this, heat by the heat source may be spread or dissipated to the outside, and the heat dissipation performance of the electronic device 200 and the surface quality of the display 230 may be improved.

Although not illustrated, additionally or optionally, the electronic device 200 according to an embodiment may include a digitizer disposed on the front surface 310A or the rear surface 310B of the first plate 310 to receive a signal by an external input device (e.g., a digital pen). The digitizer may be formed over the entire section of the display 230 or may be separated from the folding part 33.

In an embodiment, when viewed in a direction perpendicular to the display 230, a characteristic of an area of the first hinge plate 352 that overlaps the first reinforcement plate (e.g., the first reinforcement plate 372 of FIG. 3A) and/or the second reinforcement plate (e.g., the second reinforcement plate 362 of FIG. 3A) and a characteristic of an area of the first hinge plate 352 that does not overlap may be different. For example, a thickness of the area of the first hinge plate 352 that overlaps the first reinforcement plate and/or the second reinforcement plate and a thickness of the area of the first hinge plate 352 that does not overlap may be different. For example, the thickness of the area of the first hinge plate 352 that overlaps the first reinforcement plate and/or the second reinforcement plate may be smaller than the thickness of the area of the first hinge plate 352 that does not overlap. For example, the distance from the display 230 of the area of the first hinge plate 352 that overlaps the first reinforcement plate and/or the second reinforcement plate and the area of the first hinge plate 352 that does not overlap may be different. For example, the area of the first hinge plate 352 that overlaps the first reinforcement plate and/or the second reinforcement plate may be spaced farther away from the display 230 than the area of the first hinge plate 352 that does not overlap. For example, the area of the first hinge plate 352 that overlaps the first reinforcement plate and/or the second reinforcement plate may have stronger rigidity than the area of the first hinge plate 352 that does not overlap. For example, the area of the first hinge plate 352 that overlaps the first reinforcement plate and/or the second reinforcement plate may be formed of the stainless steel, and the area of the first hinge plate 352 that does not overlap may be formed of a carbon fiber reinforced plastic (CFRP) material with rigidity lower than that of the stainless steel.

In an embodiment, when viewed in the direction perpendicular to the display 230, a characteristic of an area of the second hinge plate 353 that overlaps the first reinforcement plate (e.g., the third reinforcement plate 374 of FIG. 3A) and/or the second reinforcement plate (e.g., the fourth reinforcement plate 364 of FIG. 3A) and a characteristic of an area of the second hinge plate 353 that does not overlap may be different. For example, a thickness of the area of the second hinge plate 353 that overlaps the first reinforcement plate and/or the second reinforcement plate and a thickness of the area of the second hinge plate 353 that does not overlap may be different. For example, the thickness of the area of the second hinge plate 353 that overlaps the first reinforcement plate and/or the second reinforcement plate may be smaller than the thickness of the area of the second hinge plate 353 that does not overlap. For example, the distance from the display 230 of the area of the second hinge plate 353 that overlaps the first reinforcement plate and/or the second reinforcement plate and the area of the second hinge plate 353 that does not overlap may be different. For example, the area of the second hinge plate 353 that overlaps the first reinforcement plate and/or the second reinforcement plate may be spaced farther away from the display 230 than the area of the second hinge plate 353 that does not overlap. For example, the area of the second hinge plate 353 that overlaps the first reinforcement plate and/or the second reinforcement plate may have stronger rigidity than the area of the second hinge plate 353 that does not overlap. For example, the area of the second hinge plate 353 that overlaps the first reinforcement plate and/or the second reinforcement plate may be formed of the stainless steel, and the area of the second hinge plate 353 that does not overlap may be formed of the carbon fiber reinforced plastic (CFRP) material with rigidity lower than that of the stainless steel.

In an embodiment, when viewed in the direction perpendicular to the display 230, a member (e.g., an arm member or a rotating member) of a hinge structure (e.g., the hinge structure 250 of FIG. 2C or the hinge structure 1260 of FIG. 2F) that contacts or supports the first hinge plate 352 may overlap the first reinforcement plate 372 and/or the third reinforcement plate 362. In an embodiment, when viewed in the direction perpendicular to the display 230, a member (e.g., the arm member or the rotating member) of a hinge structure (e.g., the hinge structure 250 of FIG. 2C or the hinge structure 1260 of FIG. 2F) that contacts or supports the second hinge plate 353 may overlap the second reinforcement plate 374 and/or the fourth reinforcement plate 364. Accordingly, damage or a crack due to pressing of the folding part 33 may be prevented.

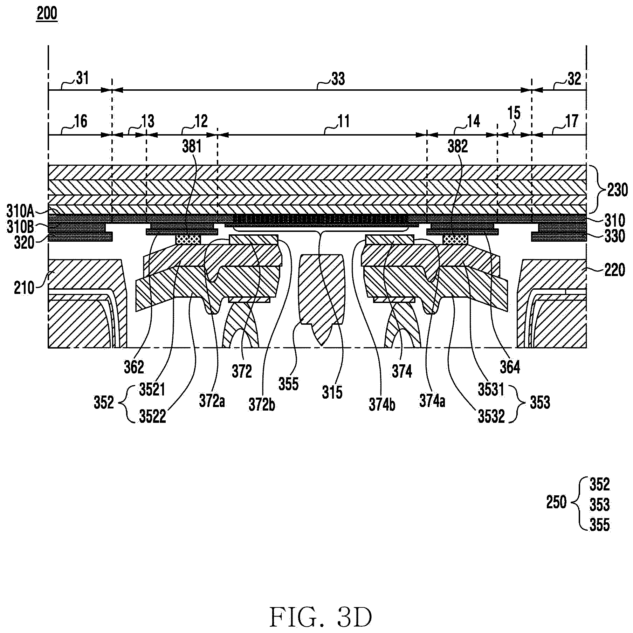

FIG. 3D is a cross-sectional view illustratively indicating an electronic device in an unfolded state according to an embodiment. Referring to FIG. 3D, an electronic device 200 according to an embodiment may further include a first adhesive member 381 and a second adhesive member 382. The first adhesive member 381 and/or the second adhesive member 382 may include a pressure sensitive adhesive (PSA), but is not limited thereto.

In an embodiment, the first adhesive member 381 may be disposed between a first hinge plate 352 and a second reinforcement plate 362 in a direction perpendicular to the first plate 310 in the unfolded state (i.e. based on the vertical direction). The first adhesive member 381 may attach the second reinforcement plate 362 to the first hinge plate 352.

In an embodiment, the second adhesive member 382 may be disposed between a second hinge plate 353 and a fourth reinforcement plate 364 in a direction perpendicular to the first plate 310 in the unfolded state (i.e. based on the vertical direction). The second adhesive member 382 may attach the fourth reinforcement plate 364 to the second hinge plate 353.

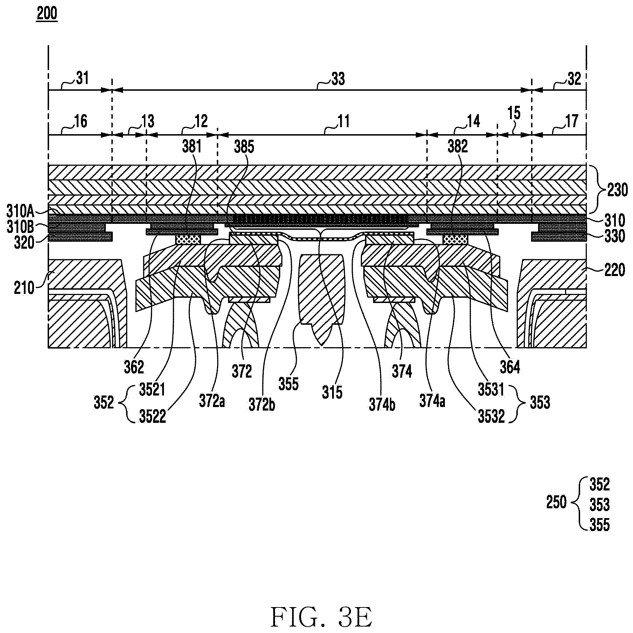

FIG. 3E is a cross-sectional view illustratively indicating an electronic device in an unfolded state according to an embodiment. Referring to FIG. 3E, an electronic device 200 according to an embodiment may further include a first adhesive member 381 and a second adhesive member 382 as described above in relation to FIG. 3D, and a heat dissipation member 385. In an embodiment, although not illustrated, the heat dissipation member 385 may be included without the first adhesive member 381 and a second adhesive member 382.

In an embodiment, the heat dissipation member 385 may be located between a first section 11 and a hinge structure 250 in a direction perpendicular to the first plate 310 in the unfolded state (i.e. based on the vertical direction). In an embodiment, the heat dissipation member 385 may extend from a first reinforcement plate 372, across a center plate 355, to a third reinforcement plate 374. A first end portion of the heat dissipation member 385 may be attached on the first reinforcement plate 372, and a second end portion of the heat dissipation member 385 opposite to the first end portion may be attached on the third reinforcement plate 374. In an embodiment, the heat dissipation member 385 may be configured to be bent according to rotation of the first hinge plate 352 and the second hinge plate 353. The heat dissipation member 385 may be formed in a sheet shape. The heat dissipation member 385 may improve heat transfer performance between a first housing 210 and a second housing 220 and heat dissipation performance of each of the first housing 210 and the second housing 220 by thermally connecting the first reinforcement plate 372 and the third reinforcement plate 374. The heat dissipation member 385 may include, for example, graphite, but is not limited thereto.

In an embodiment, the heat dissipation member 385 may include a first section attached on the first reinforcement plate 372, a second section attached on the third reinforcement plate 374, and a third section between the first section and the second section. The third section may be formed longer than a distance between the first section and the second section so as to be capable of corresponding to (or accommodate) the bending of the folding part 11. For example, the first section and the second section may be aligned on a first horizontal plane above a second horizontal plane on which the third section is aligned. That is, the distance between the support plate 310 and the third section may be greater than the distance between the support plate 310 and the first section and/or the second section. The third portion may be configured to bend according to rotation of the first hinge plate 352 and the second hinge plate 353.

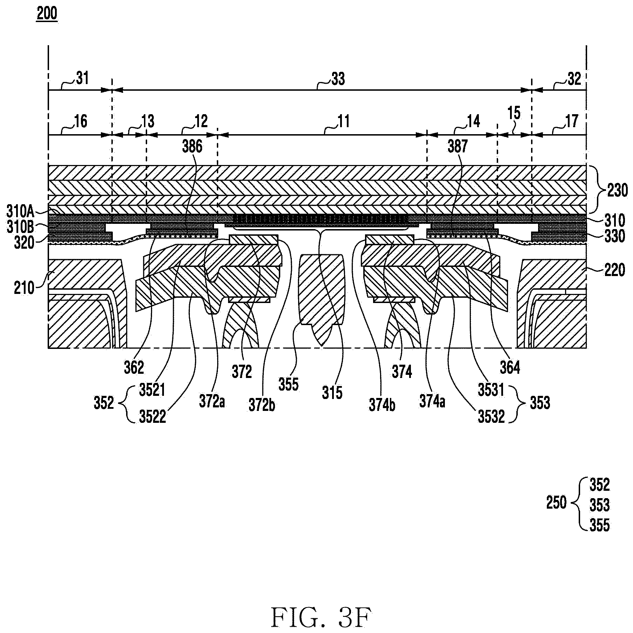

FIG. 3F is a cross-sectional view illustratively indicating an electronic device in an unfolded state according to an embodiment. Referring to FIG. 3F, an electronic device 200 according to an embodiment may further include a first heat dissipation member 386 and a second heat dissipation member 387.

In an embodiment, the first heat dissipation member 386 and the second heat dissipation member 387 may be located below a first plate 310. The first heat dissipation member 386 may extend from a second section 12, across a third section 13, and below a sixth section 16. The first heat dissipation member 386 may include a first part attached to a second reinforcement plate 362, a second part extending from the first part below the third section 13, and a third part extending from the second part and attached to a second plate 320. In an embodiment, the second part of the first heat dissipation member 386 may be configured to be bent according to a folding operation of a display 230.

In an embodiment, the second heat dissipation member 387 may extend from a fourth section 14, across a fifth section 15, and below a seventh section 17. The second heat dissipation member 387 may include a first part attached to a fourth reinforcement plate 364, a second part extending from the first part below the fifth section 15, and a third part extending from the second part and attached to a third plate 330. In an embodiment, the second part of the second heat dissipation member 387 may be configured to be bent according to a folding operation of the display 230.

In an embodiment, the first heat dissipation member 386 and the second heat dissipation member 387 may include a graphite sheet, but are not limited thereto. In an embodiment, the first heat dissipation member 386 may improve heat dissipation performance of a first housing 210 by thermally connecting the second reinforcement plate 362 and the second plate 320. In an embodiment, the second heat dissipation member 387 may improve heat dissipation performance of a second housing 220 by thermally connecting the fourth reinforcement plate 364 and the third plate 330.

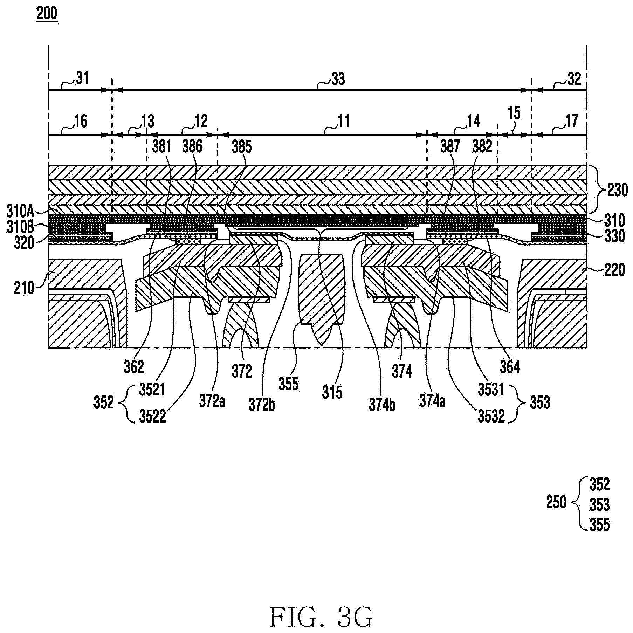

FIG. 3G is a cross-sectional view illustratively indicating an electronic device in an unfolded state according to an embodiment. Referring to FIG. 3G, an electronic device 200 according to an embodiment may further include a first adhesive member 381, a second adhesive member 382, a heat dissipation member 385 as described above in relation to FIG. 3E, and a first heat dissipation member 386 and second heat dissipation member 387 as described above in relation to FIG. 3F. In an embodiment, unlike FIGS. 3D and 3E, the first adhesive member 381 may be disposed between the first heat dissipation member 386 and a first hinge plate 352. The first adhesive member 381 may attach the first heat dissipation member 386 onto the first hinge plate 352. In an embodiment, unlike FIGS. 3D and 3E, the second adhesive member 382 may be disposed between the second heat dissipation member 387 and a second hinge plate 353. The second adhesive member 382 may attach the second heat dissipation member 387 onto the second hinge plate 353. The first adhesive member 381 and/or the second adhesive member 382 may include a pressure sensitive adhesive (PSA), but is not limited thereto.

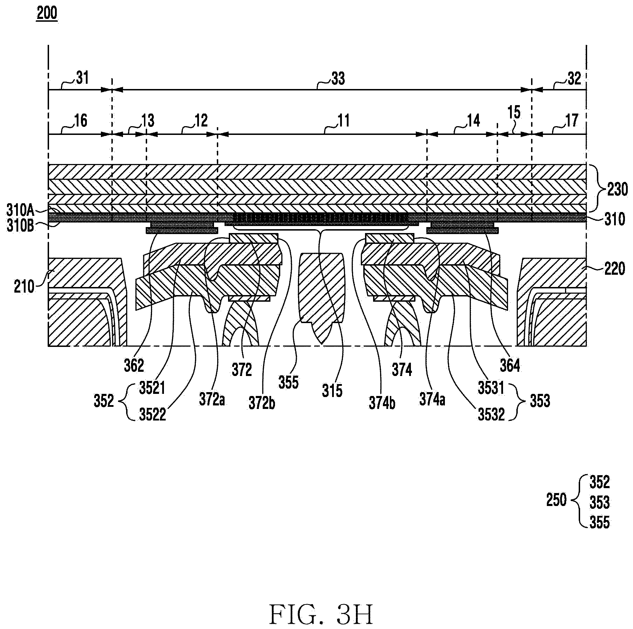

FIG. 3H is a cross-sectional view illustratively indicating an electronic device in an unfolded state according to an embodiment. Referring to FIG. 3H, an electronic device 200 according to an embodiment may not include a second plate 320 and a third plate 330 of FIG. 3A. Although not illustrated, the electronic device of FIG. 3H may further include a first adhesive member 381 and a second adhesive member 382 as described above in relation to FIGS. 3D and 3E, a heat dissipation member 385 as described above in relation to FIG. 3E, and a first heat dissipation member 386 and second heat dissipation member 387 as described above in relation to FIG. 3F. The electronic device of FIG. 3H may further include a first adhesive member 381, a second adhesive member 382, a heat dissipation member 385, a first heat dissipation member 386, and second heat dissipation member 387 as described above in relation to FIG. 3G. Unlike the embodiments of FIGS. 3F and 3G, the third part of the first heat dissipation member 386 and the third part of the second heat dissipation member 387 may be attached to the first plate 310 below the sixth section 16 and seventh section 17, respectively.

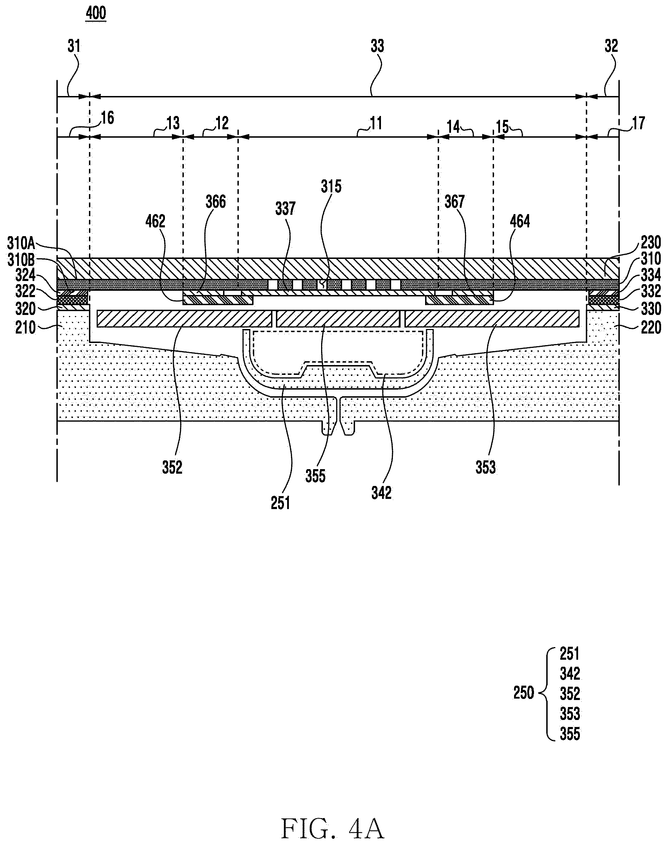

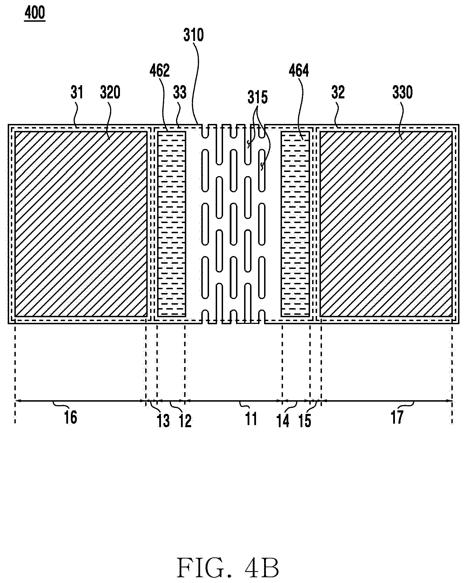

FIG. 4A is a cross-sectional view illustratively indicating an electronic device in an unfolded state according to an embodiment. FIG. 4B is a plan view illustratively indicating an electronic device in an unfolded state according to an embodiment.

Referring to FIGS. 4A and 4B, an electronic device 400 (e.g., an electronic device 200) according to an embodiment may include a first reinforcement plate 462 and a second reinforcement plate 464. The electronic device 400 may not include a first reinforcement plate 372 and a third reinforcement plate 374 of FIG. 3A. Otherwise, the above description of FIGS. 3A-3H may apply to the following description of FIGS. 4A and 4B, unless indicated otherwise. Regarding the first reinforcement plate 462 and the second reinforcement plate 464, a description provided with reference to a second reinforcement plate 362 of FIG. 3A and a fourth reinforcement plate 364 of FIG. 3A may be applied in the same or corresponding manner, and an overlapping description may be omitted.

In an embodiment, the first reinforcement plate 462 and the second reinforcement plate 464 may be located between a second plate 320 and a third plate 330 in a direction parallel to the first plate 310 in the unfolded state and perpendicular to the folding axis (i.e. in the horizontal direction). The first reinforcement plate 462 and the second reinforcement plate 464 may be located between a first plate 310 and a hinge structure 250 in a direction perpendicular to the first plate 310 in the unfolded state (i.e. in the vertical direction). The first reinforcement plate 462 and the second reinforcement plate 464 may be spaced apart from a first hinge plate 352 and a second hinge plate 353, respectively.

In an embodiment, the first reinforcement plate 462 may be disposed on a rear surface 310B of a second section 12 of the first plate 310. For example, the first reinforcement plate 462 may be attached at least partially to a rear surface of the second section 12 through an adhesive member 366. The first reinforcement plate 462 may not be attached to a third section 13.

In an embodiment, the second reinforcement plate 464 may be attached to the rear surface 310B of a fourth section 14 of the first plate 310. For example, the second reinforcement plate 464 may be attached at least partially to a rear surface of the fourth section 14 through an adhesive member 367. The second reinforcement plate 464 may not be attached to a fifth section 15.

In an embodiment, the first reinforcement plate 462 may entirely overlap the second section 12 based on a direction perpendicular to the first plate 310. The first reinforcement plate 462 may not overlap a first section 11 and the third section 13.

In an embodiment, the second reinforcement plate 464 may entirely overlap the fourth section 14 based on the direction perpendicular to the first plate 310. The second reinforcement plate 464 may not overlap the first section 11 and the fifth section 15.

In an embodiment, a protective layer 337 may include a first end portion of the protective layer 337 closer to the second section 12 and a second end portion opposite the first end portion and closer to the fourth section 14. The first end portion of the protective layer 337 may be located between the first plate 310 and the second reinforcement plate 464 in a direction perpendicular to the first plate 310 in the unfolded state (i.e. in the vertical direction). The second end portion of the protective layer 337 may be located between the first plate 310 and the second reinforcement plate 464 in a direction perpendicular to the first plate 310 in the unfolded state (i.e. in the vertical direction).

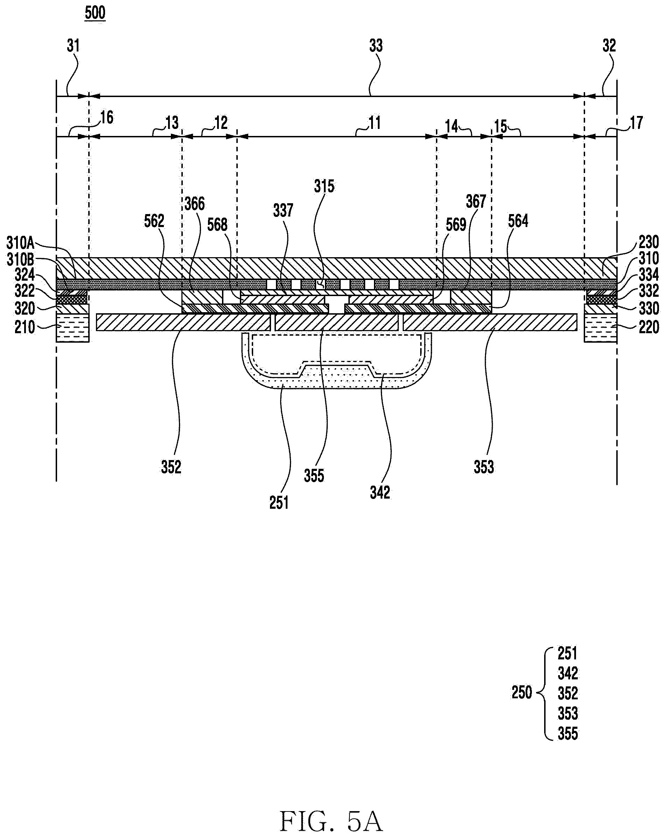

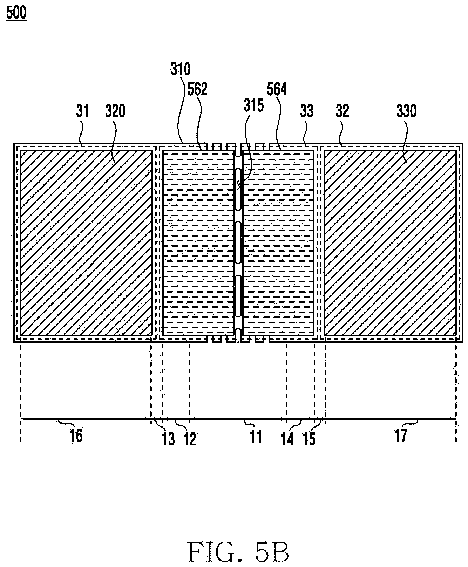

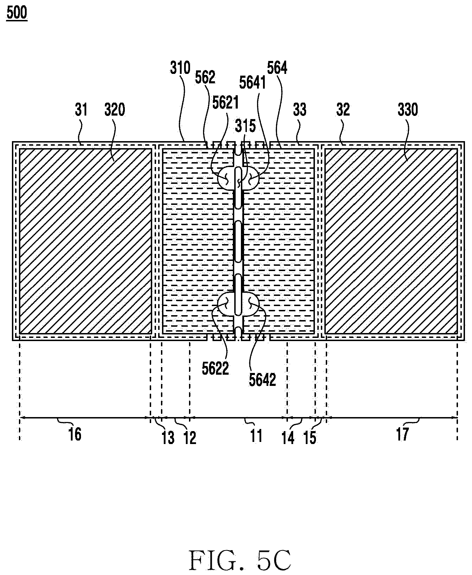

FIG. 5A is a cross-sectional view illustratively indicating an electronic device in an unfolded state according to an embodiment. FIG. 5B is a plan view illustratively indicating an electronic device in an unfolded state according to an embodiment. FIG. 5C is a plan view illustratively indicating an electronic device in an unfolded state according to an embodiment.

Referring to FIGS. 5A-5C, an electronic device 500 (e.g., an electronic device 400) according to an embodiment may include a first reinforcement plate 562 and a second reinforcement plate 564. The electronic device 500 may not include a first reinforcement plate 372 and a third reinforcement plate 374 of FIG. 3A. Otherwise, the above description of FIGS. 3A-3H and 4A-4B may apply to the following description of FIGS. 5A-5C, unless indicated otherwise. Regarding the first reinforcement plate 562, a description provided with reference to a second reinforcement plate 362 of FIG. 3A and a first reinforcement plate 462 of FIG. 4A may be applied in the same or corresponding manner, and an overlapping description may be omitted. Regarding the second reinforcement plate 564, a description provided with reference to a fourth reinforcement plate 364 of FIG. 3A and a second reinforcement plate 464 of FIG. 4A may be applied in the same or corresponding manner, and an overlapping description may be omitted.

In an embodiment, the first reinforcement plate 562 and the second reinforcement plate 564 may be located between a second plate 320 and a third plate 330 in a direction parallel to the first plate 310 in the unfolded state and perpendicular to the folding axis (i.e. in the horizontal direction). The first reinforcement plate 562 and the second reinforcement plate 564 may be located between a first plate 310 and a hinge structure 250 in a direction perpendicular to the first plate 310 in the unfolded state (i.e. in the vertical direction). The first reinforcement plate 562 and the second reinforcement plate 564 may be spaced apart from a first hinge plate 352 and a second hinge plate 353, respectively.

In an embodiment, the first reinforcement plate 562 may be disposed on a rear surface 310B of a second section 12 of the first plate 310. For example, a part of the first reinforcement plate 562 may be attached to at least a part of a rear surface of the second section 12 through an adhesive member 366. The first reinforcement plate 562 may not be attached to a third section 13.

In an embodiment, the second reinforcement plate 564 may be attached to the rear surface 310B of a fourth section 14 of the first plate 310. For example, a part of the second reinforcement plate 564 may be attached to at least a part of a rear surface of the fourth section 14 through an adhesive member 367. The second reinforcement plate 564 may not be attached to a fifth section 15.

In an embodiment, the part of the first reinforcement plate 562 may overlap a first section 11 (or a plurality of openings 315) and the other part of the first reinforcement plate 562 may overlap the second section 12, based on a direction perpendicular to the first plate 310. The first reinforcement plate 562 may not overlap the third section 13.

In an embodiment, the part of the second reinforcement plate 564 may overlap the first section 11 (or the plurality of openings 315) and the other part of the second reinforcement plate 564 may overlap the fourth section 14, based on the direction perpendicular to the first plate 310. The second reinforcement plate 564 may not overlap the fifth section 15.

When compared with FIG. 4A, the first reinforcement plate 562 may extend more than the first reinforcement plate 462 toward the third plate 330 so as to overlap a center plate 355 (or a center of the first section 11). In addition, the second reinforcement plate 564 may extend more than the second reinforcement plate 464 toward the second plate 320 so as to overlap the center plate 355 (or the center of the first section 11). Through this, an area where the first reinforcement plate 562 and the second reinforcement plate 564 support a folding part 33 of a display 230 may be increased, and surface quality of the folding part 33 may be improved.

The electronic device 500 according to an embodiment may include a first step compensation member 568 and a second step compensation member 569. The first step compensation member 568 and the second step compensation member 569 may include, for example, a metal, a plastic, or an elastic body, but are not limited thereto.

In an embodiment, the first step compensation member 568 may be disposed between a protective layer 337 and the first reinforcement plate 562 in a direction perpendicular to the first plate 310 in the unfolded state (i.e. in the vertical direction). The first step compensation member 568 may be attached on the first reinforcement plate 562. The first step compensation member 568 may be supported by the first section 11 (or the protective layer 337) of the first plate 310 in the unfolded state. For example, the first step compensation member 568 may contact the protective layer 337 in the unfolded state and may be spaced apart from the protective layer 337 in a folded state. Through this, inclination of the first reinforcement plate 562 and the display 230 may be maintained parallel in the unfolded state, and the surface quality of the folding part 33 supported by the first reinforcement plate 562 may be improved.

In an embodiment, the second step compensation member 569 may be disposed between the protective layer 337 and the second reinforcement plate 564 in a direction perpendicular to the first plate 310 in the unfolded state (i.e. in the vertical direction). The second step compensation member 569 may be attached on the second reinforcement plate 564. The second step compensation member 569 may be supported by the first section 11 (or the protective layer 337) of the first plate 310 in the unfolded state. For example, the second step compensation member 569 may contact the protective layer 337 in the unfolded state and may be spaced apart from the protective layer 337 in the folded state. Through this, inclination of the second reinforcement plate 564 and the display 230 may be maintained parallel in the unfolded state, and surface quality of the folding part 33 supported by the second reinforcement plate 564 may be improved.

Referring to FIG. 5C, according to an embodiment, the first reinforcement plate 562 may include a first opening 5621 and a second opening 5622. The first opening 5621 and the second opening 5622 may be formed on one side of the first reinforcement plate 562 facing the second reinforcement plate 564.

In an embodiment, the second reinforcement plate 564 may include a first opening 5641 and a second opening 5642. The first opening 5641 and the second opening 5642 may be formed on one side of the second reinforcement plate 564 facing the first reinforcement plate 562. The first opening 5641 of the second reinforcement plate 564 may face the first opening 5621 of the first reinforcement plate 562. The second opening 5642 of the second reinforcement plate 564 may face the second opening 5622 of the first reinforcement plate 562.

The openings 5621 and 5622 of the first reinforcement plate 562 and the openings 5641 and 5642 of the second reinforcement plate 564 may overlap a movable range of a hinge structure (e.g., the hinge structure 250 of FIG. 5A) during a folding operation. In other words, in the folded state, the openings 5621 and 5622 may prevent the first reinforcement plate 562 from interfering with the hinge structure, and the openings 5641 and 5642 may prevent the second reinforcement plate 564 from interfering with the hinge structure.

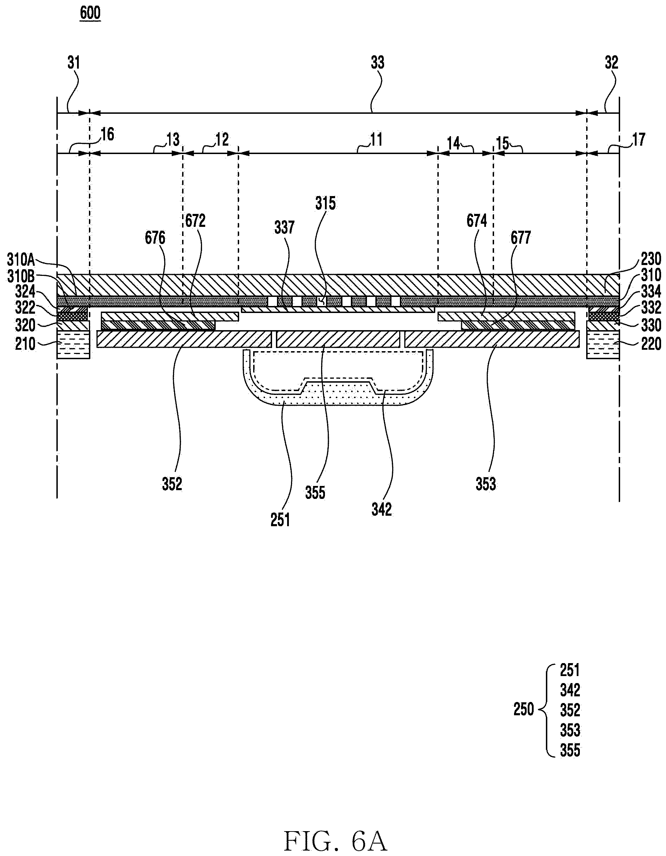

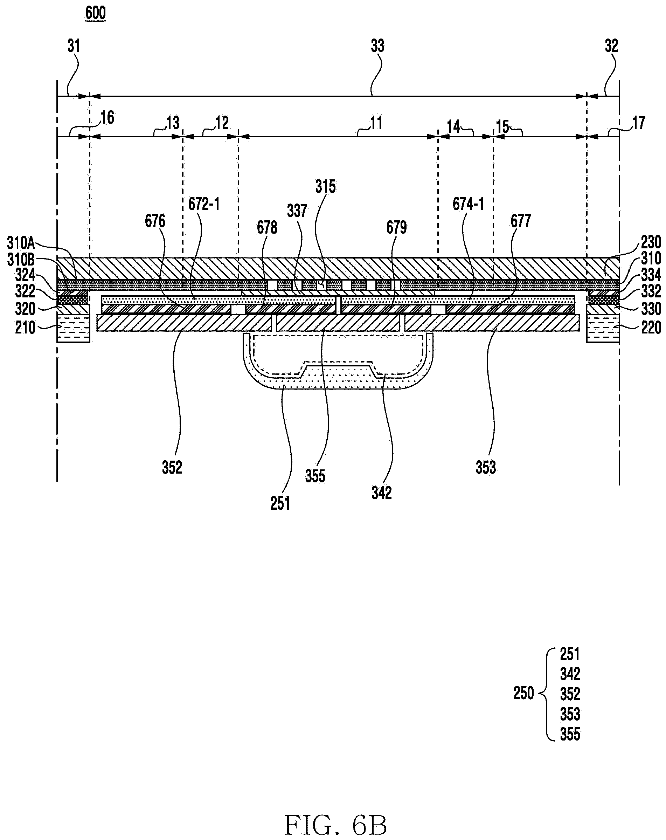

FIG. 6A is a cross-sectional view illustratively indicating an electronic device in an unfolded state according to an embodiment. FIG. 6B is a cross-sectional view illustratively indicating an electronic device in an unfolded state according to an embodiment.

Referring to FIG. 6A, an electronic device 600 (e.g., an electronic device 200 of FIG. 3A) according to an embodiment may include a first reinforcement plate 672 and a second reinforcement plate 674. The electronic device 600 may not include a second reinforcement plate 362 and a fourth reinforcement plate 364 of FIG. 3A. Otherwise, the above description of FIGS. 3A-3H may apply to the following description of FIGS. 6A-6B, unless indicated otherwise. Regarding the first reinforcement plate 672 and the second reinforcement plate 674, a description provided with reference to a first reinforcement plate 372 and a third reinforcement plate 374 of FIG. 3A may be applied in the same or corresponding manner, and an overlapping description may be omitted.

In an embodiment, the first reinforcement plate 672 and the second reinforcement plate 674 may be located between a second plate 320 and a third plate 330 in a direction parallel to the first plate 310 in the unfolded state and perpendicular to the folding axis (i.e. in the horizontal direction). The first reinforcement plate 672 and the second reinforcement plate 674 may be located between a first plate 310 and a hinge structure 250 in a direction perpendicular to the first plate 310 in the unfolded state (i.e. in the vertical direction).

In an embodiment, the first reinforcement plate 672 may be disposed on a first hinge plate 352. For example, the first reinforcement plate 672 may be attached at least partially on the first hinge plate 352 through an adhesive member 676.

In an embodiment, the second reinforcement plate 674 may be disposed on a second hinge plate 353. For example, the second reinforcement plate 674 may be attached at least partially on a second hinge plate 353 through an adhesive member 677.

In an embodiment, the first reinforcement plate 672 may include a first portion overlapping a third section 13 of the first plate 310 and a second portion overlapping a second section 12. The second portion of the first reinforcement plate 672 may extend from the first portion. In an embodiment, like a first reinforcement plate 672-1 of FIG. 6B, the first reinforcement plate 672 may further include a third portion extending from the second portion so as to overlap a first section 11 (or a plurality of openings 315) of the first plate 310. In this case, the electronic device 600 may include a first step compensation member 678 attached to the first reinforcement plate 672-1. The first step compensation member 678 (e.g., a first step compensation member 368 of FIG. 3C) may be located between the first reinforcement plate 672-1 and the first hinge plate 352 in the unfolded state. The first step compensation member 678 may be supported by the first hinge plate 352 and/or a center plate 355 in the unfolded state.

In an embodiment, the second reinforcement plate 674 may include a first portion overlapping a fifth section 15 of the first plate 310 and a second portion overlapping the fourth section 14. The second portion of the second reinforcement plate 674 may extend from the first portion. In an embodiment, like a second reinforcement plate 674-1 of FIG. 6B, the second reinforcement plate 674 may further include a third portion extending from the second portion so as to overlap the first section 11 (or the plurality of openings 315) of the first plate 310. In this case, the electronic device 600 may include a second step compensation member 679 (e.g., a second step compensation member 369 of FIG. 3C) attached to the second reinforcement plate 674-1. The second step compensation member 679 may be located between the second reinforcement plate 674-1 and the second hinge plate 353 in the unfolded state. The second step compensation member 679 may be supported by the second hinge plate 353 and/or the center plate 355 in the unfolded state.

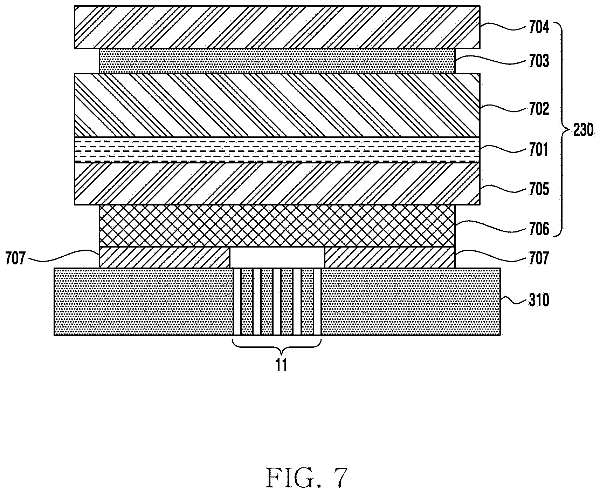

FIG. 7 is a cross-sectional view illustratively indicating a partial configuration of an electronic device according to an embodiment. Referring to FIG. 7, according to an embodiment, a display 230 (e.g. the display of any of FIGS. 3A-3H, 4A-4B, 5A-5C and 6A-6B) may include a display panel 701, a polarization layer 702 disposed on the display panel 701, a first window 703 disposed on the polarization layer 702, a second window 704 disposed on the first window 703, a first protective layer 705 disposed on a rear surface of the display panel 701, and a second protective layer 706 disposed on a rear surface of the first protective layer 705. The display panel 701, the polarization layer 702, the first window 703, the second window 704, the first protective layer 705, and the second protective layer 706 may be stacked by being attached to each other through an adhesive member (e.g., a pressure sensitive adhesive (PSA)).

Alternatively, the display 230 may not include the polarization layer 702. In this case, a color filter and a black matrix (BM) are disposed on a light emitting part of the display panel 701, so that they may perform substantially the same function as the polarization layer 702.

In an embodiment, the first window 703 and the second window 704 may be formed of a flexible transparent material. For example, the first window 703 may be formed of glass, and the second window 704 may be formed of resin (e.g., polyimide), but is not limited thereto.

In an embodiment, the first protective layer 705 and the second protective layer 706 may protect the display panel 701, by being attached to the rear surface of the display panel 701. The first protective layer 705 and/or the second protective layer 706 may be in a form of a film formed of, for example, the resin, the metal, or a composite material, but is not limited thereto.

In an embodiment, a first plate 310 may be partially attached to a rear surface of the second protective layer 706. For example, the first plate 310 may be attached to the second protective layer 706 through an adhesive layer 707 disconnected from a first section 11. In other words, the first section 11 of the first plate 310 may not be attached to the display 230.

Although not illustrated, at least one layer may be further disposed below the first plate 310. The at least one layer may include a heat dissipation layer and/or a cushion layer. The heat dissipation layer may be formed of a material having good heat dissipation performance, such as graphite. The cushion layer may be formed of a material capable of absorbing a physical impact. In case that the at least one layer is included the at least one layer, for example, may be interposed between the first plate 310 and a second plate 320 of FIG. 3A, and may be interposed between the first plate 310 and a third plate 330 of FIG. 3A, but is not limited thereto.

In FIG. 7, the display 230 is illustrated as including the display panel 701, the polarization layer 702, the first window 703, the second window 704, the first protective layer 705, and the second protective layer 706, but a configuration of the display 230 is not limited by the illustrated example. For example, the display 230 may further include the adhesive layer 707 and the first plate 310. For example, the display 230 may further include the adhesive layer 707, the first plate 310, and at least one reinforcement plate attached to the first plate 310. The at least one reinforcement plate may include, for example, at least one of a second reinforcement plate 362 of FIG. 3A and a fourth reinforcement plate 364 of FIG. 3A. The at least one reinforcement plate may include, for example, at least one of a first reinforcement plate 462 of FIG. 4A and a second reinforcement plate 464 of FIG. 4A. The at least one reinforcement plate may include, for example, at least one of a first reinforcement plate 562 of FIG. 5A and a second reinforcement plate 564 of FIG. 5A. The display 230 may be referred to as a display assembly, a touch screen display assembly, a display module, or a touch-sensitive display module, but is not limited thereto.

There follows a list of embodiments and examples. The invention may comprise any combination of the following embodiments and examples and features thereof, except where such a combination would result in a contradiction.

In an embodiment, the second plate 320 and the third plate 330 may be referred to as a first portion and a second portion of the second plate, respectively. In this case, the first portion may be understood as being attached to a rear surface 310B of the first plate 310 so as to be aligned with a first flat part 31. In addition, the second portion may be understood as being attached to the rear surface 310B of the first plate 310 so as to be aligned with a second flat part 32 and being disconnected from the first portion and the folding part 33. According to an embodiment, the electronic device (e.g., an electronic device 200 of FIG. 3A) may include a display (e.g., the display 230 of FIG. 3A), a hinge structure (e.g., a hinge structure 250 of FIG. 3A), a first plate (e.g., the first plate 310 of FIG. 3A), a second plate (e.g., the second plate 320 of FIG. 3A), a first reinforcement plate (e.g., the first reinforcement plate 372 of FIG. 3A), and a second reinforcement plate (e.g., the second reinforcement plate 362 of FIG. 3A). The display may include a first flat part (e.g., a first flat part 31 of FIG. 3A), a second flat part (e.g., a second flat part 32 of FIG. 3A) facing the first flat part in a state in which the electronic device is folded, and a folding part (e.g., a folding part 33 of FIG. 3A) located between the first flat part and the second flat part. A hinge structure below the folding part, may include a hinge bracket (e.g., a hinge bracket 342 of FIG. 3C), a first hinge plate (e.g., a first hinge plate 352 of FIG. 3A), and a second hinge plate (e.g., a second hinge plate 353 of FIG. 3A). The first hinge plate and the second hinge plate may be configured to fold or unfold the folding part by being rotatably connected to the hinge structure. The first plate may include a plurality of openings (e.g., a plurality of openings 315 of FIG. 3A) located between the hinge structure and the folding part. The first plate may extend across the folding part from the first flat part to the second flat part. The front surface (e.g., a front surface 310A of FIG. 3A) of the support plate may be attached to a rear surface of the display. The second plate may be attached to the rear surface (e.g., a rear surface 310B of FIG. 3A) of the first plate so as to be aligned with the first plane part. The first reinforcement plate may be located between the first plate and the hinge structure. The first reinforcement plate may be attached to the first hinge plate. The second reinforcement plate may be spaced apart from the second plate. The second reinforcing plate may be attached to the rear surface of the first plate between the second plate and the first reinforcement plate. Through the first reinforcement plate and the second reinforcement plate, surface quality of the display may be improved.

In an embodiment, the first plate may include a first section (e.g., a first section 11 of FIG. 3A), a second section (e.g., a second section 12 of FIG. 3A), and a third section (e.g., a third section 13 of FIG. 3A) under the folding part. The first section may include the plurality of openings. The second section may extend from one side of the first section. The second reinforcement plate may be attached to the second section. The third section may extend from the second section to the first flat part. The hinge structure may be changeable between an unfolded state and a folded state. In the unfolded state, a first direction toward which one surface of the first flat part faces is the same as a second direction toward which one surface of the second flat part faces. In the folded state, the first direction may be opposite to the second direction. In the folded state, a curvature sign of the first section may be opposite to a curvature sign of the third section.

In an embodiment, in the folded state or the unfolded state, the second section may be substantially flat.

In an embodiment, the second reinforcement plate may not be attached to the third section. The second reinforcement plate may not interfere with the display in the folded state, and may improve the surface quality of the display in the unfolded state.

In an embodiment, in the unfolded state, the second reinforcement plate may not overlap the third section based on a direction perpendicular to the support plate. The second reinforcement plate may not interfere with the display in the folded state, and may improve the surface quality of the display in the unfolded state.

In the unfolded state, the first reinforcement plate may at least partially overlap the first section based on a direction perpendicular to the first plate.

In an embodiment, in the unfolded state a portion of the first reinforcement plate may overlap the first section. In the unfolded state, a remain portion of the first reinforcement plate may overlap the second section.

In an embodiment, in the unfolded state, the first and second reinforcement plates may support the rear surface of the first plate. Accordingly, the surface quality of the display may be improved in the unfolded state.

In an embodiment, the hinge structure may include a hinge cover (e.g., a hinge cover 251 of FIG. 3C) aligned with a center portion of the first section of the first plate. The first reinforcement plate may include a first side (e.g., a first side 372a of FIG. 3C) and a second side (e.g., a second side 372b of FIG. 3C) opposite to the first side. In the unfolded state, the first side of the first reinforcement plate may face the second plate. In the unfolded state, the second side of the first reinforcement plate may be located between the center portion of the first section of the first plate and the hinge cover.

In an embodiment, the hinge structure may include a center plate (e.g., a center plate 355 of FIG. 3A). In the unfolded state, the center plate may be located between the first hinge plate and the second hinge plate. In the unfolded state, the first reinforcement plate may partially overlap the center plate based on a vertical direction.

The electronic device according to an embodiment may comprise may include a third plate (e.g., a third plate 330 of FIG. 3A), a third reinforcement plate (e.g., a third reinforcement plate 374 of FIG. 3A), and a fourth reinforcement plate (e.g., a fourth reinforcement plate 364 of FIG. 3A). The third plate may be attached to the rear surface of the first plate so as to be aligned with the second flat part. The third reinforcement plate may be located between the first plate and the hinge structure, and may be attached to the second hinge plate. The fourth reinforcement plate may be spaced apart from the third plate, and may be attached to the rear surface of the first plate between the third plate and the third reinforcement plate. The first plate may include a fourth section (e.g., a fourth section 14 of FIG. 3A) and a fifth section (e.g., a fifth section 15 of FIG. 3A), which are under the folding part. The fourth section may extend from another side of the first section. The fourth reinforcement plate may be attached to the fourth section. The fifth section may extend from fourth section to the second flat part. The surface quality of the display may be improved through the third reinforcement plate and the fourth reinforcement plate.

In an embodiment, in the folded state, a curvature sign of the first section may be opposite to a curvature sign of the fifth section.

In an embodiment, the fourth section, in the folded state or the unfolded state, may be substantially flat.

In an embodiment, the fourth reinforcement plate may not be attached to the fifth section. The fourth reinforcement plate may not interfere with the display in the folded state, and may improve the surface quality of the display in the unfolded state.

In an embodiment, in the unfolded state, the fourth reinforcement plate may not overlap the fifth section based on the direction perpendicular to the first plate.

In an embodiment, in the unfolded state, the third reinforcement plate may at least partially overlap the first section based on the direction perpendicular to the first plate.

In an embodiment, in the unfolded state, a part of the third reinforcement plate may overlap the first section. In the unfolded state, the remaining part of the third reinforcement plate may overlap the fourth section.

In an embodiment, in the unfolded state, the third reinforcement plate and the fourth reinforcement plate may support the rear surface of the first plate. Accordingly, the surface quality of the display may be improved in the unfolded state.

In an embodiment, the hinge structure may include a hinge cover (e.g., the hinge cover 251 of FIG. 3C) aligned with a center portion of the first section of the first plate. The third reinforcement plate may include a first side (e.g., a first side 374a of FIG. 3C) and a second side (e.g., a second side 374b of FIG. 3C) opposite to the first side. In the unfolded state, the first side of the third reinforcement plate may face the third plate. In the unfolded state, the second side of the third reinforcement plate may be located between the center portion of the first section of the first plate and the hinge cover. The first reinforcement plate may include the first side (e.g., the first side 372a of FIG. 3C) and the second side (e.g., the second side 372b of FIG. 3C) opposing each other. In the unfolded state, the first side of the first reinforcement plate may face the second plate. In the unfolded state, the second side of the first reinforcement plate may face the second side of the third reinforcement plate and may be located between the center portion of the first section of the first plate and the hinge cover.

In an embodiment, the hinge structure may include the center plate (e.g., the center plate 355 of FIG. 3A). In the unfolded state, the center plate may be located between the first hinge plate and the second hinge plate. In the unfolded state, the first reinforcement plate may partially overlap the center plate based on a vertical direction. In the unfolded state, the third reinforcement plate may partially overlap the center plate based on the vertical direction.

The electronic device according to an embodiment may comprise a first step compensation member (e.g., a first step compensation member 368 of FIG. 3C) attached to the first reinforcement plate, and a second step compensation member (e.g., a second step compensation member 369 of FIG. 3C) attached to the third reinforcement plate. The first step compensation member, in the unfolded state, may be supported by at least one of the first hinge plate and the center plate. The second step compensation member, in the unfolded state, may be supported by at least one of the second hinge plate and the center plate. As the first step compensation member and the second step compensation member maintain the first reinforcement plate and the third reinforcement plate in parallel with the display in the unfolded state, the surface quality of the display supported by the first reinforcement plate and the third reinforcement plate may be improved.

The electronic device according to an embodiment may comprise a first adhesive layer (e.g., a first adhesive layer 322 of FIG. 3C) interposed between the first plate and the second plate, a first elastic layer (e.g., a first elastic layer 324 of FIG. 3C) interposed between the first adhesive layer and the first plate, a second adhesive layer (e.g., a second adhesive layer 332 of FIG. 3C) interposed between the first plate and the third plate, and a second elastic layer (e.g., a second elastic layer 334 of FIG. 3C) interposed between the second adhesive layer and the first plate.

The electronic device according to an embodiment may include a protective member (e.g., a protective layer 337 of FIG. 3C) attached to the rear surface of the first plate so as to cover the plurality of openings. The protective member may alleviate impact that may be applied to the folding part of the display and may prevent foreign substances from flowing into the plurality of openings.

In an embodiment, the first plate may include a sixth section (e.g., a sixth section 16 of FIG. 3A) extending from the third section and a seventh section (e.g., a seventh section 17 of FIG. 3A) extending from the fifth section. A front surface of the sixth section may be attached to a rear surface of the first flat part. The second plate may be attached to a rear surface of the sixth section. The front surface of the seventh section may be attached to a rear surface of the second flat part. The third plate may be attached to a rear surface of the seventh section. In the unfolded state or the folded state, the sixth section and the seventh section may be substantially flat.

The electronic device according to an embodiment may comprise a first bracket (e.g., a first housing 210 of FIG. 3A) supporting the first flat part, a second bracket (e.g., a second housing 220 of FIG. 3A) supporting the second flat part, a printed circuit board (e.g., a printed circuit board 261 of FIG. 2C) supported by the first bracket, an application processor (e.g., a processor 120 of FIG. 1) on the printed circuit board. Each of the first bracket and the second bracket may be rotatably coupled to the hinge bracket. At least one of the first bracket, the first plate, the second plate, the first reinforcement plate, and the second reinforcement plate may be formed of a material with higher thermal conductivity than the second bracket to spread heat generated by the application processor. Accordingly, heat dissipation performance by the application processor may be improved.

An electronic device according to an embodiment (e.g., an electronic device 400 of FIG. 4A, an electronic device 500 of FIG. 5A, or an electronic device 600 of FIG. 6A) may comprise a display (e.g., a display 230 of FIG. 4A), a hinge structure (e.g., a hinge structure 250 of FIG. 4A), a first plate (e.g., a first plate 310 of FIG. 4A), a second plate, a first reinforcement plate (e.g., a first reinforcement plate 462 of FIG. 4A, a first reinforcement plate 562 of FIG. 5A, a first reinforcement plate 672 of FIG. 6A, or a first reinforcement plate 672-1 of FIG. 6B), and a second reinforcement plate (e.g., a second reinforcement plate 464 of FIG. 4A, a second reinforcement plate 564 of FIG. 5A, a second reinforcement plate 674 of FIG. 6A, or a second reinforcement plate 674-1 of FIG. 6B). The display may include a first flat portion (e.g., a first flat portion 31 of FIG. 4A), a second flat portion (e.g., a second flat portion 32 of FIG. 4A) spaced apart from the first flat portion, and a folding portion (e.g., a folding portion 33 of FIG. 4A) connecting the first flat portion to the second flat portion. The hinge structure below the folding portion, may include a hinge bracket (e.g., a hinge bracket 342 of FIG. 4A), a first hinge plate (e.g., a first hinge plate 352 of FIG. 4A), and a second hinge plate (e.g., a second hinge plate 353 of FIG. 4A). The first hinge plate and the second hinge plate may be configured to fold or unfold the folding portion by being rotatably coupled to the hinge bracket. The first plate may include a plurality of openings (e.g., a plurality of openings 315 of FIG. 4A) located between the hinge structure and the folding portion, and may extend across the folding portion from the first flat portion to the second flat portion. The front surface of the first plate may be attached to a rear surface of the display. The second plate may include a first portion (e.g., a second plate 320 of FIG. 4A) attached to a rear surface (e.g., a rear surface 310B of FIG. 4A) of the support plate to be aligned with the first flat portion and may include a second portion attached to the rear surface of the first plate to be aligned with the second flat portion and disconnected from the first portion. The first and second reinforcement plates may be positioned between the first portion and the second portion of the second plate and may be positioned between the first plate and the hinge structure. The hinge structure may be changeable between an unfolded state and a folded state. In the unfolded state, a first direction toward which one surface of the first flat portion faces is the same as a second direction toward which one surface of the second flat portion faces, and in the folded state, the first direction may be opposite to the second direction. The support plate may include a first section (e.g., a first section 11 of FIG. 4A), a second section (e.g., a second section 12 of FIG. 4A), and a third section (e.g., a third section 13 of FIG. 4A), which are under the folding part. The first section may extend from the second section to the third section. The first section may include a plurality of openings. the second section and the third section may remain flat in the folded state and the unfolded state. In the unfolded state, the first hinge plate may be aligned with the second section, and the second hinge plate may be aligned with the third section. The first reinforcement plate may be attached to the second section of the first plate or the first hinge plate. The second reinforcement plate may be attached to the third section of the first plate or the second hinge plate. The surface quality of the display may be improved through the first reinforcement plate and the second reinforcement plate.

In an embodiment, the first plate may include a fourth section (e.g., a fourth section 14 of FIG. 4A) and a fifth section (e.g., a fifth section 15 of FIG. 4A), which are under the folding part. The second section may extend from one side of the first section to the fourth section. The third section may extend from another side of the first section to the fifth section. In the folded state, a curvature sign of the first section may be opposite to a curvature sign of the fourth section and a curvature sign of the fifth section.

In an embodiment, the first reinforcement plate may not be attached to the fourth section, and the second reinforcement plate may not be attached to the fifth section. The second reinforcement plate may not interfere with the display in the folded state, and may improve the surface quality of the display in the unfolded state.

In an embodiment, in the unfolded state, the first reinforcement plate may partially overlap the plurality of openings. The second reinforcement plate may partially overlap the plurality of openings.

In an embodiment, the electronic device may include a protective member (e.g., a protective layer 337 of FIG. 4A) attached to the rear surface of the first plate to cover the plurality of openings. By the protective member, an impact applied to the folding part of the display may be alleviated and foreign substances may be prevented from flowing into the plurality of openings.

In an embodiment, the first step compensation member (e.g., a first step compensation member 568 of FIG. 5A or a first step compensation member 678 of FIG. 6B) attached to the first reinforcement plate, and the second step compensation member (e.g., a second step compensation member 569 of FIG. 5A or a second step compensation member 679 of FIG. 6B) attached to the second reinforcement plate may be included. In the unfolded state, the first step compensation member may be located between the first reinforcement plate and the protective member, and the second step compensation member may be located between the second reinforcement plate and the protective member. The first step compensation member and the second step compensation member may improve surface quality of the display supported by the first reinforcement plate and the third reinforcement plate, by maintaining the first reinforcement plate and the third reinforcement plate parallel to the display in the unfolded state.

In an embodiment, the first reinforcement plate may include a first side and a second side opposite to the first side. The second reinforcement plate may include a third side facing the first side of the first reinforcement plate and a fourth side opposite to the third side. A first opening (e.g., a first opening 5621 of FIG. 5C) may be formed in the first side of the first reinforcement plate. A second opening (e.g., a first opening 5641 of FIG. 5C) facing the first opening may be formed in the third side of the second reinforcement plate.

In an embodiment, the first reinforcement plate may be attached to a rear surface of the second section of the first plate. The second reinforcement plate may be attached to a rear surface of the third section of the first plate.

In an embodiment, the first reinforcement plate may be attached to the first hinge plate, and the second reinforcement plate may be attached to the second hinge plate.

In an embodiment, the first reinforcement plate may be attached to the first hinge plate and may partially overlap the fourth section in the unfolded state. The second reinforcement plate may be attached to the second hinge plate and may partially overlap the fifth section in the unfolded state.

According to an embodiment, an electronic device (e.g., an electronic device 200 of FIG. 3A) may include a display (e.g., a display 230 of FIG. 3A), a hinge structure (e.g., a hinge structure 250 of FIG. 3A), a support plate (e.g., a support plate 310 of FIG. 3A), a first reinforcement plate (e.g., a first reinforcement plate 372 of FIG. 3A), and a second reinforcement plate (e.g., a second reinforcement plate 362 of FIG. 3A). The display may include a first flat part (e.g., a first flat part 31 of FIG. 3A), a second flat part (e.g., a second flat part 32 of FIG. 3A) facing the first flat part in a state in which the electronic device is folded, and a folding part (e.g., a folding part 33 of FIG. 3A) located between the first flat part and the second flat part. The hinge structure below the folding part, may include a hinge bracket (e.g., a hinge bracket 342 of FIG. 3C), a first hinge plate (e.g., a first hinge plate 352 of FIG. 3A), and a second hinge plate (e.g., a second hinge plate 353 of FIG. 3A). The first hinge plate and the second hinge plate may be configured to fold or unfold the folding part by being rotatably connected to the hinge structure. The support plate may include a plurality of openings (e.g., a plurality of openings 315 of FIG. 3A) located between the hinge structure and the folding part. The support plate may extend across the folding part from the first flat part to the second flat part. A front surface (e.g., a front surface 310A of FIG. 3A) of the support plate may be attached to a rear surface of the display. The first reinforcement plate may be located between the support plate and the hinge structure. The first reinforcement plate may be attached to the first hinge plate. The second reinforcement plate may be located between the support plate and the hinge structure. The second reinforcement plate may be attached to the rear surface of the support plate. Through the first reinforcement plate and the second reinforcement plate, the surface quality of the display may be improved.

The electronic device according to an embodiment may include a first plate (e.g., a second plate 320 of FIG. 3A) attached to the rear surface of the support plate to be aligned with the first flat part. The support plate may include a first section (e.g., the first section 11 of FIG. 3A), a second section (e.g., the second section 12 of FIG. 3A), and a third section (e.g., the third section 13 of FIG. 3A) under the folding part. The first section may include the plurality of openings. The second section may not include an opening. The second section may extend from one side of the first section. The second reinforcement plate may be attached to the second section. The third section may extend from the second section to the first flat part. The hinge structure may be changeable between an unfolded state and a folded state. In the unfolded state, a first direction toward which one surface of the first flat part faces is the same as a second direction toward which one surface of the second flat part faces. In the folded state, the first direction may be opposite to the second direction. In the folded state, a curvature sign of the first section may be opposite to a curvature sign of the third section.

In an embodiment, in the folded state or the unfolded state, the second section may be substantially flat.

In an embodiment, the second reinforcement plate may not be attached to the third section. The second reinforcement plate may not interfere with the display in the folded state, and may improve the surface quality of the display in the unfolded state.

In an embodiment, in the unfolded state, the second reinforcement plate may not overlap the third section based on a direction perpendicular to the support plate. The second reinforcement plate may not interfere with the display in the folded state, and may improve the surface quality of the display in the unfolded state.

In the unfolded state, the first reinforcement plate may at least partially overlap the first section based on a direction perpendicular to the support plate.

In an embodiment, in the unfolded state, a part of the first reinforcement plate may overlap the first section based on the direction perpendicular to the support plate. In the unfolded state, the remaining part of the first reinforcement plate may overlap the second section based on the direction perpendicular to the support plate.

In an embodiment, in the unfolded state, the first and second reinforcement plates may support the rear surface of the support plate. Accordingly, the surface quality of the display may be improved in the unfolded state.

In an embodiment, the hinge structure may include a hinge cover (e.g., a hinge cover 251 of FIG. 3C) aligned with a center portion of the first section of the support plate. The first reinforcement plate may include a first side (e.g., a first side 372a of FIG. 3C) and a second side (e.g., a second side 372b of FIG. 3C) opposite to the first side. In the unfolded state, the first side of the first reinforcement plate may face the first plate. In the unfolded state, the second side of the first reinforcement plate may be located between the center portion of the first section of the support plate and the hinge cover.

In an embodiment, the hinge structure may include a center plate (e.g., a center plate 355 of FIG. 3A). In the unfolded state, the center plate may be located between the first hinge plate and the second hinge plate. In the unfolded state, the first reinforcement plate may partially overlap the center plate based on a vertical direction.

The electronic device according to an embodiment may comprise may include a second plate (e.g., a third plate 330 of FIG. 3A), a third reinforcement plate (e.g., a third reinforcement plate 374 of FIG. 3A), and a fourth reinforcement plate (e.g., a fourth reinforcement plate 364 of FIG. 3A). The second plate may be attached to the rear surface of the support plate so as to be aligned with the second flat part. The third reinforcement plate may be located between the support plate and the hinge structure, and may be attached to the second hinge plate. The fourth reinforcement plate may be spaced apart from the second plate, and may be attached to the rear surface of the support plate between the second plate and the third reinforcement plate. The support plate may include a fourth section (e.g., a fourth section 14 of FIG. 3A) and a fifth section (e.g., a fifth section 15 of FIG. 3A), which are under the folding part. The fourth section may extend from another side of the first section. The fourth reinforcement plate may be attached to the fourth section. The fifth section may extend from fourth section to the second flat part. The surface quality of the display may be improved through the third reinforcement plate and the fourth reinforcement plate.

In an embodiment, in the folded state, a curvature sign of the first section may be opposite to a curvature sign of the fifth section.

In an embodiment, the fourth section, in the folded state or the unfolded state, may be substantially flat.

In an embodiment, the fourth reinforcement plate may not be attached to the fifth section. The fourth reinforcement plate may not interfere with the display in the folded state, and may improve the surface quality of the display in the unfolded state.

In an embodiment, in the unfolded state, the fourth reinforcement plate may not overlap the fifth section based on the direction perpendicular to the support plate.

In an embodiment, in the unfolded state, the third reinforcement plate may at least partially overlap the first section based on the direction perpendicular to the support plate.

In an embodiment, in the unfolded state, a part of the third reinforcement plate may overlap the first section. In the unfolded state, the remaining part of the third reinforcement plate may overlap the fourth section.

In an embodiment, in the unfolded state, the third reinforcement plate and the fourth reinforcement plate may support the rear surface of the support plate. Accordingly, the surface quality of the display may be improved in the unfolded state.

In an embodiment, the hinge structure may include a hinge cover (e.g., a hinge cover 251 of FIG. 3C) aligned with a center portion of the first section of the support plate. The third reinforcement plate may include a first side (e.g., a first side 374a of FIG. 3C) and a second side (e.g., a second side 374b of FIG. 3C) opposite to the first side. In the unfolded state, the first side of the third reinforcement plate may face the second plate. In the unfolded state, the second side of the third reinforcement plate may be located between the center portion of the first section of the support plate and the hinge cover. The first reinforcement plate may include a first side (e.g., a first side 372a of FIG. 3C) and a second side (e.g., a second side 372b of FIG. 3C), which are opposed to each other. In the unfolded state, the first side of the first reinforcement plate may face the first plate. In the unfolded state, the second side of the first reinforcement plate may face the second side of the third reinforcement plate, and may be located between the central portion of the first section of the support plate and the hinge cover.

In an embodiment, the hinge structure may include the center plate (e.g., the center plate 355 of FIG. 3A). In the unfolded state, the center plate may be located between the first hinge plate and the second hinge plate. In the unfolded state, the first reinforcement plate may partially overlap the center plate based on a vertical direction. In the unfolded state, the third reinforcement plate may partially overlap the center plate based on the vertical direction.

The electronic device according to an embodiment may comprise a first step compensation member (e.g., a first step compensation member 368 of FIG. 3C) attached to the first reinforcement plate, and a second step compensation member (e.g., a second step compensation member 369 of FIG. 3C) attached to the third reinforcement plate. The first step compensation member, in the unfolded state, may be supported by at least one of the first hinge plate and the center plate. The second step compensation member, in the unfolded state, may be supported by at least one of the second hinge plate and the center plate. As the first step compensation member and the second step compensation member maintain the first reinforcement plate and the third reinforcement plate in parallel with the display in the unfolded state, the surface quality of the display supported by the first reinforcement plate and the third reinforcement plate may be improved.

The electronic device according to an embodiment may comprise a first adhesive layer (e.g., a first adhesive layer 322 of FIG. 3C) interposed between the support plate and the first plate, a first elastic layer (e.g., a first elastic layer 324 of FIG. 3C) interposed between the first adhesive layer and the support plate, a second adhesive layer (e.g., a second adhesive layer 332 of FIG. 3C) interposed between the support plate and the second plate, and a second elastic layer (e.g., a second elastic layer 334 of FIG. 3C) interposed between the second adhesive layer and the support plate.

The electronic device according to an embodiment may include a protective member (e.g., a protective layer 337 of FIG. 3C) attached to the rear surface of the support plate so as to cover the plurality of openings. The protective member may alleviate impact that may be applied to the folding part of the display and may prevent foreign substances from flowing into the plurality of openings.

In an embodiment, the support plate may include a sixth section (e.g., a sixth section 16 of FIG. 3A) extending from the third section and a seventh section (e.g., a seventh section 17 of FIG. 3A) extending from the fifth section. A front surface of the sixth section may be attached to a rear surface of the first flat part. The first plate may be attached to a rear surface of the sixth section. The front surface of the seventh section may be attached to a rear surface of the second flat part. The second plate may be attached to a rear surface of the seventh section. In the unfolded state or the folded state, the sixth section and the seventh section may be substantially flat.

The electronic device according to an embodiment may comprise a first bracket (e.g., a first housing 210 of FIG. 3A) supporting the first flat part, a second bracket (e.g., a second housing 220 of FIG. 3A) supporting the second flat part, a printed circuit board (e.g., a printed circuit board 261 of FIG. 2C) supported by the first bracket, an application processor (e.g., a processor 120 of FIG. 1) on the printed circuit board. Each of the first bracket and the second bracket may be rotatably coupled to the hinge bracket. At least one of the first bracket, the support plate, the first plate, the first reinforcement plate, and the second reinforcement plate may be formed of a material with higher thermal conductivity than the second bracket to spread heat generated by the application processor. Accordingly, heat dissipation performance by the application processor may be improved.

An electronic device according to an embodiment (e.g., an electronic device 400 of FIG. 4A, an electronic device 500 of FIG. 5A, or an electronic device 600 of FIG. 6A) may comprise a display (e.g., a display 230 of FIG. 4A), a hinge structure (e.g., a hinge structure 250 of FIG. 4A), a support plate (e.g., a support plate 310 of FIG. 4A), a first plate, a first reinforcement plate (e.g., a first reinforcement plate 462 of FIG. 4A, a first reinforcement plate 562 of FIG. 5A, a first reinforcement plate 672 of FIG. 6A, or a first reinforcement plate 672-1 of FIG. 6B), and a second reinforcement plate (e.g., a second reinforcement plate 464 of FIG. 4A, a second reinforcement plate 564 of FIG. 5A, a second reinforcement plate 674 of FIG. 6A, or a second reinforcement plate 674-1 of FIG. 6B). The display may include a first flat portion (e.g., a first flat portion 31 of FIG. 4A), a second flat portion (e.g., a second flat portion 32 of FIG. 4A) spaced apart from the first flat portion, and a folding portion (e.g., a folding portion 33 of FIG. 4A) connecting the first flat portion to the second flat portion. The hinge structure below the folding portion, may include a hinge bracket (e.g., a hinge bracket 342 of FIG. 4A), a first hinge plate (e.g., a first hinge plate 352 of FIG. 4A), and a second hinge plate (e.g., a second hinge plate 353 of FIG. 4A). The first hinge plate and the second hinge plate may be configured to fold or unfold the folding portion by being rotatably coupled to the hinge bracket. The support plate may include a plurality of openings (e.g., a plurality of openings 315 of FIG. 4A) located between the hinge structure and the folding portion, and may extend across the folding portion from the first flat portion to the second flat portion. The front surface of the support plate may be attached to a rear surface of the display. The first plate may include a first portion (e.g., a second plate 320 of FIG. 4A) attached to a rear surface (e.g., a rear surface 310B of FIG. 4A) of the support plate to be aligned with the first flat portion and may include a second portion (e.g., a third plate 330 of FIG. 4A) attached to the rear surface of the support plate to be aligned with the second flat portion and disconnected from the first portion. The first and second reinforcement plates may be positioned between the first portion and the second portion of the first plate, and may be positioned between the support plate and the hinge structure. The hinge structure may be changeable between an unfolded state and a folded state. In the unfolded state, a first direction toward which one surface of the first flat portion faces may be the same as a second direction toward which one surface of the second flat portion faces, and in the folded state, the first direction may be opposite to the second direction. The support plate may include a first section (e.g., the first section 11 of FIG. 4A), a second section (e.g., the second section 12 of FIG. 4A), and a third section (e.g., the third section 13 of FIG. 4A), which are under the folding part. The first section may extend from the second section to the third section. The first section may include a plurality of openings. The second section and the third section may remain flat in the folded state and the unfolded state. In the unfolded state, the first hinge plate may be aligned with the second section, and the second hinge plate may be aligned with the third section. The first reinforcement plate may be attached to the second section of the support plate or the first hinge plate. The second reinforcement plate may be attached to the third section of the support plate or the second hinge plate. The surface quality of the display may be improved through the first reinforcement plate and the second reinforcement plate.

In an embodiment, the support plate may include a fourth section (e.g., a fourth section 14 of FIG. 4A) and a fifth section (e.g., a fifth section 15 of FIG. 4A), which are under the folding part. The second section may extend from one side of the first section to the fourth section. The third section may extend from another side of the first section to the fifth section. In the folded state, a curvature sign of the first section may be opposite to a curvature sign of the fourth section and a curvature sign of the fifth section.

In an embodiment, the first reinforcement plate may not be attached to the fourth section, and the second reinforcement plate may not be attached to the fifth section. The second reinforcement plate may not interfere with the display in the folded state, and may improve the surface quality of the display in the unfolded state.

In an embodiment, in the unfolded state, the first reinforcement plate may partially overlap the plurality of openings. The second reinforcement plate may partially overlap the plurality of openings.

In an embodiment, the electronic device may include a protective member (e.g., a protective layer 337 of FIG. 4A) attached to the rear surface of the support plate to cover the plurality of openings. By the protective member, an impact applied to the folding part of the display may be alleviated and foreign substances may be prevented from flowing into the plurality of openings.

In an embodiment, the first step compensation member (e.g., a first step compensation member 568 of FIG. 5A or a first step compensation member 678 of FIG. 6B) attached to the first reinforcement plate, and the second step compensation member (e.g., a second step compensation member 569 of FIG. 5A or a second step compensation member 679 of FIG. 6B) attached to the second reinforcement plate may be included. In the unfolded state, the first step compensation member may be located between the first reinforcement plate and the protective member, and the second step compensation member may be located between the second reinforcement plate and the protective member. The first step compensation member and the second step compensation member may improve surface quality of the display supported by the first reinforcement plate and the third reinforcement plate, by maintaining the first reinforcement plate and the third reinforcement plate parallel to the display in the unfolded state.

In an embodiment, the first reinforcement plate may include a first side and a second side opposite to the first side. The second reinforcement plate may include a third side facing the first side of the first reinforcement plate and a fourth side opposite to the third side. A first opening (e.g., a first opening 5621 of FIG. 5C) may be formed in the first side of the first reinforcement plate. A second opening (e.g., a first opening 5641 of FIG. 5C) facing the first opening may be formed in the third side of the second reinforcement plate.

In an embodiment, the first reinforcement plate may be attached to a rear surface of the second section of the support plate. The second reinforcement plate may be attached to a rear surface of the third section of the support plate.

In an embodiment, the first reinforcement plate may be attached to the first hinge plate, and the second reinforcement plate may be attached to the second hinge plate.

In an embodiment, the first reinforcement plate may be attached to the first hinge plate and may partially overlap the fourth section in the unfolded state. The second reinforcement plate may be attached to the second hinge plate and may partially overlap the fifth section in the unfolded state.

In a first example, an electronic device is provided comprising: a display including a first flat part, a second flat part configured to face the first flat part in a state in which the electronic device is folded, and a folding part located between the first flat part and the second flat part; a hinge structure below the folding part, the hinge structure including a hinge bracket, a first hinge plate, and a second hinge plate, wherein the first hinge plate and the second hinge plate are configured to enable folding or unfolding of the folding part by being rotatably connected to the hinge bracket; a support plate located between the hinge structure and the folding part, and extending across the folding part from the first flat part to the second flat part, wherein the support plate includes a plurality of openings and wherein a front surface of the support plate is attached to a rear surface of the display; a first reinforcement plate located between the support plate and the hinge structure and attached to the first hinge plate; and a second reinforcement plate located between the support plate and the hinge structure and attached to a rear surface of the support plate.

In a second example, there is provided the electronic device of the first example, comprising: a first plate attached to the rear surface of the support plate so as to be aligned with the first flat part, and wherein: the support plate includes a first section, a second section, and a third section, which are under the folding part; the first section includes the plurality of openings; the second section does not include an opening, and extends from one side of the first section; the second reinforcement plate is attached to the second section; the third section extends from the second section to the first flat part; the hinge structure is changeable between an unfolded state and a folded state; in the unfolded state, a first direction toward which one surface of the first flat part faces is the same as a second direction toward which one surface of the second flat part faces; in the folded state, the first direction is opposite to the second direction; in the folded state, a curvature sign of the first section is opposite to a curvature sign of the third section.

In a third example, the electronic device of the second example is provided, wherein, in the folded state or the unfolded state, the second section is substantially flat.

In a fourth example, the electronic device of the second example or the third example is provided, wherein the second reinforcement plate is not attached to the third section.

In a fifth example, the electronic device of any one of the second to fourth examples is provided, wherein, in the unfolded state, the second reinforcement plate does not overlap the third section based on a direction perpendicular to the support plate.

In a sixth example, the electronic device of any one of the second to fifth examples is provided, wherein, in the unfolded state, the first reinforcement plate at least partially overlaps the first section based on a direction perpendicular to the support plate.

In a seventh example, the electronic device of the sixth example is provided, wherein, in unfolded state, based on the direction perpendicular to the support plate: a portion of the first reinforcement plate overlaps the first section; and a remaining portion of the first reinforcement plate overlaps the second section.

In an eighth example, the electronic device of any one of the second to seventh examples is provided, wherein, in unfolded state, the first and second reinforcement plates support the rear surface of the support plate.

In a ninth example, the electronic device of any one of the second to eighth examples is provided, wherein: the hinge structure includes a hinge cover aligned with a center portion of the first section of the support plate; the first reinforcement plate includes a first side and a second side opposite to the first side; in the unfolded state: the first side of the first reinforcement plate faces the first plate; and the second side of the first reinforcement plate is located between the center portion of the first section of the support plate and the hinge cover.

In a tenth example, the electronic device of any one of the second to ninth examples is provided, wherein: the hinge structure includes a center plate; in the unfolded state: the center plate is located between the first hinge plate and the second hinge plate; and the first reinforcement plate partially overlaps the center plate based on a vertical direction.

In an eleventh example, the electronic device of any one of the second to tenth examples is provided, comprising: a second plate attached to the rear surface of the support plate so as to be aligned with the second flat part; a third reinforcement plate located between the support plate and the hinge structure and attached to the second hinge plate; and a fourth reinforcement plate spaced apart from the second plate and attached to the rear surface of the support plate between the second plate and the third reinforcement plate, and wherein: the support plate includes a fourth section and a fifth section, which are under the folding part; the fourth section extends from another side of the first section; the fourth reinforcement plate is attached to the fourth section; and the fifth section extends from fourth section to the second flat part.

In a twelfth example, the electronic device of the eleventh example is provided, wherein: in the folded state, a curvature sign of the first section is opposite to a curvature sign of the fifth section.

In a thirteenth example, the electronic device of the eleventh or twelfth examples is provided, wherein the fourth section, in the folded state or the unfolded state, is substantially flat.

In a fourteenth example, the electronic device of any of the eleventh to thirteenth examples is provided, wherein the fourth reinforcement plate is not be attached to the fifth section.

In a fifteenth example, there is provided the electronic device of any of the eleventh to fourteenth examples, wherein in the unfolded state, the fourth reinforcement plate does not overlap the fifth section based on the direction perpendicular to the support plate.

In a sixteenth example, there is provided the electronic device of any of the eleventh to fifteenth examples, wherein in the unfolded state, the third reinforcement plate at least partially overlaps the first section based on the direction perpendicular to the support plate.

In a seventeenth example, there is provided the electronic device of the sixteenth example, wherein in the unfolded state, a part of the third reinforcement plate overlaps the first section, and wherein in the unfolded state, the remaining part of the third reinforcement plate overlaps the fourth section.

In an eighteenth example, there is provided the electronic device of any of the eleventh to seventeenth examples, wherein in the unfolded state, the third reinforcement plate and the fourth reinforcement plate support the rear surface of the support plate.

In a nineteenth example, there is provided the electronic device of any of the eleventh to eighteenth examples wherein: the hinge structure includes a hinge cover aligned with a center portion of the first section of the support plate; the third reinforcement plate includes a first side and a second side opposite to the first side; in the unfolded state: the first side of the third reinforcement plate faces the second plate; and the second side of the third reinforcement plate is located between the center portion of the first section of the support plate and the hinge cover; the first reinforcement plate includes a first and second sides opposing each other; in unfolded state: the first side of the first reinforcement plate faces the first plate; and the second side of the first reinforcement plate faces the second side of the third reinforcement plate and is located between the center portion of the first section of the support plate and the hinge cover.

In a twentieth example, there is provided the electronic device of the nineteenth example, wherein: the hinge structure includes a center plate; in the unfolded state: the center plate is located between the first hinge plate and the second hinge plate; the first reinforcement plate partially overlaps the center plate based on a vertical direction; the third reinforcement plate partially overlaps the center plate based on a vertical direction.

In a twenty-first example, there is provided the electronic device of the twentieth example, further comprising: a first step compensation member attached to the first reinforcement plate; and a second step compensation member attached to the third reinforcement plate, and wherein: the first step compensation member, in the unfolded state, is supported by at least one of the first hinge plate and the center plate; and the second step compensation member, in the unfolded state, is supported by at least one of the second hinge plate and the center plate.

In a twenty-second example, there is provided the electronic device of any of the eleventh to the twenty-first examples, further comprising: a first adhesive layer interposed between the support plate and the first plate; a first elastic layer interposed between the first adhesive layer and the support plate; a second adhesive layer interposed between the support plate and the second plate; a second elastic layer interposed between the second adhesive layer and the support plate; and/or a protection member attached to the rear surface of the support plate to cover the plurality of openings.

In a twenty-third example, there is provided the electronic device of any of the eleventh to the twenty-second examples, wherein: the support plate includes a sixth section extending from the third section and the seventh section extending from the fifth section; a front surface of the sixth section is attached to a rear surface of the first flat part; the first plate is attached to a rear surface of the sixth section; a front surface of the seventh section is attached to a rear surface of the second flat part; the second plate is attached to a rear surface of the seventh section; in the unfolded state or the folded state, the sixth section and the seventh section are substantially flat.

In a twenty-fourth example, there is provided the electronic device of any preceding example, further comprising a first adhesive member configured to attach the second reinforcement plate to the first hinge plate.

In a twenty-fifth example, there is provided the electronic device of any of the second to twenty-third examples, further comprising a first heat dissipation member comprising a first part attached to a second reinforcement plate, a second part extending from the first part below the third section, and a third part extending from the second part and attached to the first plate.

In a twenty-sixth example, there is provided the electronic device of the twenty-fifth example, further comprising a first adhesive member configured to attach the first heat dissipation member to the first hinge plate.

In a twenty-seventh example, there is provided the electronic device of any of the eleventh to twenty-fourth examples, further comprising a second adhesive member configured to attach the fourth reinforcement plate to the second hinge plate.

In a twenty-eighth example, there is provided the electronic device of the twenty-fifth example, further comprising a second heat dissipation member comprising a first part attached to the fourth reinforcement plate, a second part extending from the first part below the fifth section, and a third part extending from the second part and attached to the second plate.

In a twenty-ninth example, there is provided the electronic device of the twenty-eighth example, further comprising a second adhesive member configured to attach the second heat dissipation member onto the second hinge plate.

In a thirtieth example, there is provided the electronic device of any of the eleventh to twenty-ninth examples, further comprising a heat dissipation member configured to extend from the first reinforcement plate to the third reinforcement plate; wherein a first end portion of the heat dissipation member is attached on the first reinforcement plate, and a second end portion of the heat dissipation member opposite to the first end portion is attached on the third reinforcement plate.

In a thirty-first example, there is provided the electronic device of any preceding example, further comprising: a first bracket supporting the first flat part; a second bracket supporting the second flat part; a printed circuit board supported by the first bracket; and an application processor on the printed circuit board, and wherein: each of the first bracket and the second bracket is rotatably coupled to the hinge bracket; and at least one of the first bracket, the support plate, the first plate, the first reinforcement plate, and the second reinforcement plate is formed of a material with higher thermal conductivity than the second bracket to spread heat generated by the application processor.

In a thirty-second example, there is provided an electronic device comprising: a display including a first flat portion, a second flat portion spaced apart from the first flat portion, and a folding portion connecting the first flat portion to the second flat portion; a hinge structure below the folding portion, the hinge structure being changeable between an unfolded state and a folded state, and the hinge structure including a hinge bracket, a first hinge plate, and a second hinge plate, and wherein: the first hinge plate and the second hinge plate are configured to enable folding or unfolding of the folding portion by being rotatably coupled to the hinge bracket, in the unfolded state, a first direction toward which one surface of the first flat portion faces is the same as a second direction toward which one surface of the second flat portion faces, in the folded state, the first direction is opposite to the second direction; a support plate located between the hinge structure and the folding portion, and extending across the folding portion from the first flat portion to the second flat portion, wherein the support plate includes a plurality of openings and wherein a front surface of the support plate is attached to a rear surface of the display; a first plate including a first portion attached to a rear surface of the support plate to be aligned with the first flat portion and including a second portion attached to the rear surface of the support plate to be aligned with the second flat portion and disconnected from the first portion; and first and second reinforcement plates positioned between the first portion and the second portion of the first plate and positioned between the support plate and the hinge structure; wherein: the support plate includes a first section, a second section, and a third section, which are under the folding part; the first section extends from the second section to the third section and includes a plurality of openings; the second section and the third section remain flat in the folded state and the unfolded state; in the unfolded state, the first hinge plate is aligned with the second section, and the second hinge plate is aligned with the third section; the first reinforcement plate is attached to the second section of the support plate or the first hinge plate; and the second reinforcement plate is attached to the third section of the support plate or the second hinge plate.

In a thirty-third example, there is provided the electronic device of the thirty-second example, wherein: the support plate includes a fourth section and a fifth section, which are under the folding part; the second section extends from one side of the first section to the fourth section; the third section extends from another side of the first section to the fifth section; and in the folded state, a curvature sign of the first section is opposite to a curvature sign of the fourth section and a curvature sign of the fifth section.

In a thirty-fourth example, there is provided the electronic device of the thirty-second or thirty-third examples, wherein the first reinforcement plate may not be attached to the fourth section, and the second reinforcement plate may not be attached to the fifth section.

In a thirty-fifth example, there is provided the electronic device of any of the thirty-second to thirty-fourth examples, wherein in the unfolded state, the first reinforcement plate partially overlaps the plurality of openings, and wherein the second reinforcement plate partially overlaps the plurality of openings.

In a thirty-sixth example, there is provided the electronic device of any of the thirty-second to thirty-fifth examples, wherein the electronic device includes a protective member attached to the rear surface of the support plate to cover the plurality of openings.

In a thirty-seventh example, there is provided the electronic device of any of the thirty-second to thirty-sixth examples, further comprising a first step compensation member attached to the first reinforcement plate, and a second step compensation member attached to the second reinforcement plate. In the unfolded state, the first step compensation member is located between the first reinforcement plate and the protective member, and the second step compensation member is located between the second reinforcement plate and the protective member.

In a thirty-eighth example, there is provided the electronic device of any of the thirty-second to thirty-seventh examples, wherein the first reinforcement plate includes a first side and a second side opposite to the first side. The second reinforcement plate includes a third side facing the first side of the first reinforcement plate and a fourth side opposite to the third side. A first opening is formed in the first side of the first reinforcement plate. A second opening facing the first opening may be formed in the third side of the second reinforcement plate.

In a thirty-ninth example, there is provided the electronic device of any of the thirty-second to thirty-eighth examples, wherein the first reinforcement plate is attached to a rear surface of the second section of the support plate. The second reinforcement plate is attached to a rear surface of the third section of the support plate.

In a fortieth example, there is provided the electronic device of any of the thirty-second to thirty-eighth examples, wherein the first reinforcement plate may be attached to the first hinge plate, and the second reinforcement plate may be attached to the second hinge plate.

In a forty-first example, there is provided the electronic device of the fortieth example, wherein the first reinforcement plate may be attached to the first hinge plate and may partially overlap the fourth section in the unfolded state. The second reinforcement plate may be attached to the second hinge plate and may partially overlap the fifth section in the unfolded state.

The technical task to be achieved in the present document is not limited to the above-mentioned technical task, and other technical tasks not mentioned will be clearly understood by those who have ordinary knowledge in the technical field belonging to the present document from the following description.

The effect that may be obtained in the present disclosure is not limited to the above-mentioned effects, and other effects not mentioned will be clearly understood by those who have ordinary knowledge in the technical field to which the present disclosure belongs from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a display including a first flat part, a second flat part configured to face the first flat part in a state in which the electronic device is folded, and a folding part located between the first flat part and the second flat part;
a hinge structure below the folding part, the hinge structure including a hinge bracket, a first hinge plate, and a second hinge plate, wherein the first hinge plate and the second hinge plate are configured to enable folding or unfolding of the folding part by being rotatably connected to the hinge bracket;
a support plate located between the hinge structure and the folding part, and extending across the folding part from the first flat part to the second flat part, wherein the support plate includes a plurality of openings and wherein a front surface of the support plate is attached to a rear surface of the display;
a first reinforcement plate located between the support plate and the hinge structure and attached to the first hinge plate; and
a second reinforcement plate located between the support plate and the hinge structure and attached to a rear surface of the support plate.

2. The electronic device of claim 1, comprising:
a first plate attached to the rear surface of the support plate so as to be aligned with the first flat part, and wherein:
the support plate includes a first section, a second section, and a third section, which are under the folding part;
the first section includes the plurality of openings;
the second section does not include an opening, and extends from one side of the first section;
the second reinforcement plate is attached to the second section;
the third section extends from the second section to the first flat part;
the hinge structure is changeable between an unfolded state and a folded state;
in the unfolded state, a first direction toward which one surface of the first flat part faces is the same as a second direction toward which one surface of the second flat part faces;
in the folded state, the first direction is opposite to the second direction;
in the folded state, a curvature sign of the first section is opposite to a curvature sign of the third section.

3. The electronic device of claim 2,
wherein, in the folded state or the unfolded state, the second section is substantially flat.

4. The electronic device of claim 2 or claim 3,
wherein the second reinforcement plate is not attached to the third section.

5. The electronic device of any one of claims 2 to 4,
wherein, in the unfolded state, the second reinforcement plate does not overlap the third section based on a direction perpendicular to the support plate.

6. The electronic device of any one of claims 2 to 5,
wherein, in the unfolded state, the first reinforcement plate at least partially overlaps the first section based on a direction perpendicular to the support plate.

7. The electronic device of claim 6, wherein, in unfolded state, based on the direction perpendicular to the support plate:
a portion of the first reinforcement plate overlaps the first section; and
a remaining portion of the first reinforcement plate overlaps the second section.

8. The electronic device of any one of claims 2 to 7,
wherein, in unfolded state, the first and second reinforcement plates support the rear surface of the support plate.

9. The electronic device of any one of claims 2 to 8, wherein:
the hinge structure includes a hinge cover aligned with a center portion of the first section of the support plate;
the first reinforcement plate includes a first side and a second side opposite to the first side;
in the unfolded state:
the first side of the first reinforcement plate faces the first plate; and
the second side of the first reinforcement plate is located between the center portion of the first section of the support plate and the hinge cover.

10. The electronic device of any one of claims 2 to 9, wherein:
the hinge structure includes a center plate;
in the unfolded state:
the center plate is located between the first hinge plate and the second hinge plate; and
the first reinforcement plate partially overlaps the center plate based on a vertical direction.

11. The electronic device of any one of claims 2 to 10, comprising:
a second plate attached to the rear surface of the support plate so as to be aligned with the second flat part;
a third reinforcement plate located between the support plate and the hinge structure and attached to the second hinge plate; and
a fourth reinforcement plate spaced apart from the second plate and attached to the rear surface of the support plate between the second plate and the third reinforcement plate, and wherein:
the support plate includes a fourth section and a fifth section, which are under the folding part;
the fourth section extends from another side of the first section;
the fourth reinforcement plate is attached to the fourth section; and
the fifth section extends from fourth section to the second flat part.

12. The electronic device of claim 11, wherein:
in the folded state, a curvature sign of the first section is opposite to a curvature sign of the fifth section; and
the fourth section, in the folded state or the unfolded state, is substantially flat.

13. The electronic device of claim 11 or claim 12, wherein:
the hinge structure includes a hinge cover aligned with a center portion of the first section of the support plate;
the third reinforcement plate includes a first side and a second side opposite to the first side;
in the unfolded state:
the first side of the third reinforcement plate faces the second plate; and
the second side of the third reinforcement plate is located between the center portion of the first section of the support plate and the hinge cover;
the first reinforcement plate includes a first and second sides opposing each other;
in unfolded state:
the first side of the first reinforcement plate faces the first plate; and
the second side of the first reinforcement plate faces the second side of the third reinforcement plate and is located between the center portion of the first section of the support plate and the hinge cover.

14. The electronic device of claim 13, wherein:
the hinge structure includes a center plate;
in the unfolded state:
the center plate is located between the first hinge plate and the second hinge plate;
the first reinforcement plate partially overlaps the center plate based on a vertical direction;
the third reinforcement plate partially overlaps the center plate based on a vertical direction.

15. The electronic device of claim 14, further comprising:
a first step compensation member attached to the first reinforcement plate; and
a second step compensation member attached to the third reinforcement plate, and wherein:
the first step compensation member, in the unfolded state, is supported by at least one of the first hinge plate and the center plate; and
the second step compensation member, in the unfolded state, is supported by at least one of the second hinge plate and the center plate.
